(19) Europäisches Patentamt
European Patent Office
Office européen des brevets

(11) **EP 2 082 426 B1**

(12) **EUROPEAN PATENT SPECIFICATION**

(45) Date of publication and mention
of the grant of the patent:
**26.12.2012 Bulletin 2012/52**

(51) Int Cl.:
***G11C 13/00*** *(2006.01)*    ***H01L 27/10*** *(2006.01)*

(21) Application number: **07864165.1**

(22) Date of filing: **08.11.2007**

(86) International application number:
**PCT/US2007/084183**

(87) International publication number:
**WO 2008/058264 (15.05.2008 Gazette 2008/20)**

(54) **CORRELATED ELECTRON MEMORY**

KORRELIERTER ELEKTRONENSPEICHER

MÉMOIRE D'ÉLECTRONS CORRÉLÉS

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **08.11.2006 US 858218 P
02.03.2007 US 904768 P
09.03.2007 US 906158 P
21.05.2007 US 931245 P**

(43) Date of publication of application:
**29.07.2009 Bulletin 2009/31**

(73) Proprietor: **SYMETRIX CORPORATION
Colorado Springs, CO 80918 (US)**

(72) Inventors:
• **PAZ DE ARAUJO, Carlos A.
Colorado Springs, CO 80919 (US)**
• **BRUBAKER, Matthew D.
Colorado Springs, CO 80903 (US)**
• **CELINSKA, Jolanta
Colorado Springs, CO 80919 (US)**

(74) Representative: **Tönhardt, Marion
Boehmert & Boehmert
Pettenkoferstrasse 20-22
80336 München (DE)**

(56) References cited:
EP-A- 1 433 874     EP-A- 1 484 799
EP-A- 1 489 068     EP-A- 1 617 482
EP-A- 1 622 163     WO-A-2006/062317
WO-A-2007/026509    WO-A-2007/138646
US-A1- 2003 054 615  US-A1- 2003 234 397
US-A1- 2004 124 407  US-A1- 2004 183 647
US-A1- 2006 050 549  US-A1- 2006 145 240
US-A1- 2006 152 961

## Description

*1. Field Of The Invention*

The invention in general relates to integrated circuit memories, and in particular, to the formation of non-volatile integrated circuit memories containing materials which exhibit a change in resistance.

*2. Background Of The Invention*

Non-volatile memories are a class of integrated circuits in which the memory cell or element does not lose its state after the power supplied to the device is turned off. The earliest computer memories, made with rings of ferrite that could be magnetized in two directions were non-volatile. As semiconductor technology evolved into higher levels of miniaturization, the ferrite devices were abandoned for the more commonly known volatile memories such as DRAMs (Dynamic Random Access memories) and SRAMs (Static-RAMs).

The need for non-volatile memories never went away. Thus, in the last forty years, many devices were created to fulfill this need. In the late 70's, devices were made with a metallization layer which either connected or disconnected a cell. Thus, at the factory one could set values in a non-volatile way. Once these devices left the factory, they could not be re-written. They were called ROMs (Read Only Memories). in 1967, Khang and SZE at Bell Laboratories proposed devices which were made using field effect transistors (FETs) which had within layers of materials in the gate, the ability to trap charge. In the late 70's and early 80's devices which could be written by the user and erased by de-trapping the electrons via ultra-violet light (UV) were very successful. The UV both required the device to be removed from the circuit board and placed under a UV lamp for over 15 minutes. These non-volatile memories were called PROMs or programmable - ROMs. The writing process involved forcing current from the substrate below to these trap sites. This process of making the electrons pass through layers of materials which have an opposing potential energy barrier is known as quantum tunneling, a phenomenon that only occurs because of the wave-particle duality of the electron. Many types of sandwiches of materials for the gate stack of these FETs were tried and the technology received many names such as MNOS (Metal-Nitride-Oxide-Semiconductor), SNOS ([Poly] Silicon-Gate Plus MNOS), SONOS (Silicon-Oxide Plus MNOS) and PS/O/PS/S (Polysilicon Control Gate--Silicon Dioxide - Polysilicon Floating Gate -- and a thin tunneling oxide on top of the silicon substrate). This kind of erasable and thus read/write non-volatile device was known as EEPROMs for electrically-erasable-PROMs, an unfortunate misnomer since they are not just read only. Typically EEPROMS have large cell areas and require a large voltage (from 12-21 volt) on the gate in order to write/erase. Also, the erase or write time is of the order of tens of microseconds. However, the worse limiting factor is the limited number of erase/write cycles to no more than slightly over 600,000 - or of the order of $10^5$ - $10^6$. The semiconductor industry eliminated the need of a pass-gate switch transistor between EEPROMs non-volatile transistors by sectorizing the memory array in such a way that "pages" (sub-arrays) could be erased at a time in memories called Flash memories. In Flash memories, the ability to keep random access (erase/write single bits) was sacrificed for speed and higher bit density.

The desire to have low power, high speed, high density and indestructibility has kept researchers working in non-volatile memory for the last forty years. FeRAMs (Ferroelectric RAMs) provide low power, high write/read speed and endurance for read/write cycles exceeding 10 billion times. Magnetic memories (MRAMs) provide high write/read speed and endurance, but with a high cost premium and higher power consumption. Neither of these technologies reaches the density of Flash, and thus Flash remains the non-volatile memory of choice. However, it is generally recognized that Flash will not scale easily below 65 nanometers; thus, new non-volatile memories that will scale to smaller sizes are actively being sought.

To this end, there has been much research over the last ten to twenty years on memories based on certain materials that exhibit a resistance change associated with a change of phase of the material. In one type of variable resistance memory called an PCM (phase change memory), a change in resistance occurs when the memory element is briefly melted and then cooled to either a conductive crystalline state or a nonconductive amorphous state. Typical materials vary and include GeSbTe, where Sb and Te can be exchanged with other elements of same properties on the Periodic Table. These materials are often referred to as chalcogenides. See, for example, Stephan Lai, "Current Status of the Phase Change Memory and Its Future", Intel Corporation, Research note RN2-05 (2005); United States Patent No. 7,038,935 issued to Darrell Rinerson et al., May 2, 2006; United States Patent No. 6,903,361 issued to Terry L. Gilton on June 7, 2005; and United States Patent No. 6,841,833 issued to Sheng Teng Hsu et al., January 11, 2005. However, these resistance-based memories have not proved to be commercially useful because their transition from the conductive to the insulating state depends on a physical structure phenomenon, i.e., melting (at up to 600°C) and returning to a solid state that cannot be sufficiently controlled for a useful memory.

Recently, a resistance switching field effect transistor has been disclosed using a Mott-Brinkman-Rice insulator, such as $LaTiO_3$. In this material, according to the theory proposed, the addition of holes via an interface with a $Ba_{(1-x)}Sr_x TiO_3$ layer changes the material from an insulator to a conductor. See United States Patent No. 6,624,463 issued to Hyun-Tak Kim et al. on September 23, 2003. This FET uses the Mott-Brinkman-Rice insulator as the channel in the FET. However, no example of fabrication of actual devices is given.

Another variable resistance memory category includes materials that require an initial high "forming" voltage and current to activate the variable resistance function. These materials include $Pr_xCa_yM_zO_\varepsilon$, with x, y, z and $\varepsilon$ of varying stoichiometry, transition metal oxides, such as CuO, CoO, $VO_x$, NiO, $TiO_2$, $Ta_2O_5$, and some perovskites such as Cr; $SrTiO_3$. See, for example, "Resistive Switching Mechanisms of TiO2 Thin Films Grown By Atomic-Layer Deposition", B. J. Choi et al., Journal of Applied Physics 98, 033715(2005), "Reproducible Resistive Switching In Nonstoichiometric Nickel Oxide Films Grown By RF Reactive Sputtering For Resistive Random Access Memory Applications", Jae-Wan Park, et al., J. Vac. Sci. Technol. A 23(5), Sept/Oct 2005, "Influence Of Oxygen Content On Electrical Properties Of NiO films grown By RF Reactive Sputtering", Jae-Wan Park, et al., J. Vac. Sci. Technol. B 24(5), Sept/Oct 2006, "Nonpolar Resistance Switching Of Metal/Binary-Transition-Metal Oxides/Metal Sandwiches: Homogeneous/inhomogeneous Transition of Current Distribution", I.H. Inone et al., arXiv:Cond-mat/0702564 v.1 26Feb2007, and United States Patent Application Publication No. 2007/0114509 A1, *Memory Cell Comprising Nickel-Cobalt Oxide Switching Element,* on an application of S. Brad Herner. These memories are referred to as ReRAMs, to distinguish them from the chalcogenide type memories. These papers postulate that the resistance switching is due to the formation of narrow conducting paths or filaments connecting the top and bottom electrodes by the electroforming process, though the presence of such conducting filaments are still a matter of controversy with respect to the actual physical mechanism. It is believed by Applicants that when electroforming is used the bulk of the non-filament region does not provide true memory switching but a metastable electron storage which is due to charge trapping and detrapping in oxygen vacancies. This is further evidenced by the fact that none of these papers demonstrate conductive and insulative states that are stable over the necessary temperature range for a commercial memory. Further, the resistance switching tends to fatigue over many memory cycles. Moreover, based on the ReRAM art to date, the use of such materials must be said to be speculative, since the high voltage-high current electroforming step simply is not compatible with dense chip architecture. In fact, the Herner patent application reference merely speculates that a combination of nickel and cobalt oxides will eliminate the required high amplitude pulses, without providing an actual example to demonstrate it.

EP1489068 discloses multidental ligands for memory application. EP1484799 discloses a nonvolatile memory device comprising a switching device and a resistant material. In summary, there have been literally hundreds if not thousands of papers and patent applications written on resistive memories in the last ten years, most of which have been speculative. However, a workable resistance switching memory has never been made, because no one knows how to make a thin film resistance switching material that is stable over time and temperature. Further, all resistance switching mechanisms developed up to now have been inherently unsuitable for memories, due to high currents, electroforming, no measurable memory windows over a reasonable range of temperatures and voltages, and many other problems. Thus, there remains a need in the art for a non-volatile memory that has low power, high speed, high density and stability, and in particular, such a memory that is scalable to feature sizes well below 65 nanometers.

## SUMMARY OF THE INVENTION

The invention solves the above and other problems by incorporating a Correlated Electron Material (CEM) in a memory, preferably a non-volatile memory. CEMs are materials that exhibit an abrupt conductor/insulator transition due to electron correlations rather than solid state structural phase changes, i.e., crystalline/amorphous, or filamentary phase changes. Because these materials have never before been used in a memory, those skilled in the memory art are generally unfamiliar with them. Therefore, a more complete description of these materials will be given in the Detailed Description of the Invention below.

A feature of the invention is that the CEM materials are formed in the conductive state, and no forming voltage or current is necessary to change them into a variable resistance material.

Another feature of the preferred embodiment of the invention is that the correlated electron materials of the invention are essentially homogeneous. By "essentially homogeneous" is meant that the crystal structure is uniform through the bulk of the material, though there may be surface effects that create different structures at the surfaces than in the bulk.

Another feature of the invention is that the conductor/insulator transition may be induced simply by the application of a small voltage or current to the material, i.e., a voltage of the order of the voltage applied to a DRAM, that is, no more than five volts and, more preferably, no more than a few volts.

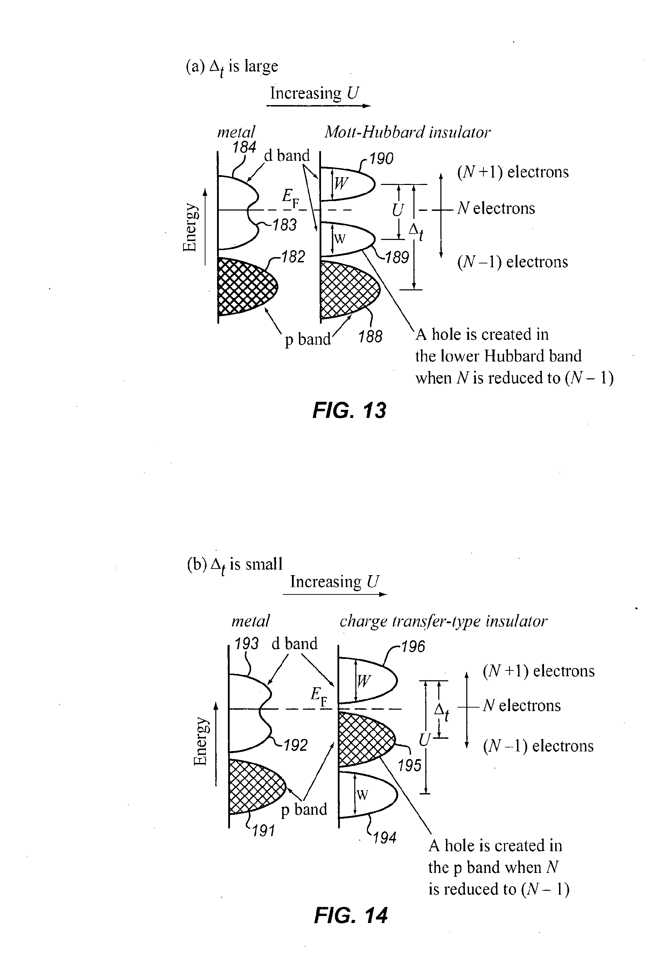

The conductor/insulator transition in the memory according to the invention is a purely quantum mechanical phenomenon, in contrast to melting/solidification or filament formation, which are classical physics phenomena. The quantum mechanical transition can be understood in several ways. One way is in terms of band structure. When the materials are formed, the relevant electron orbitals, i.e., the bands that are being filled by the increasing electrons in each succeeding element in the period table, overlap. In the transition metal oxides, these are d-orbitals. This creates a partially-filled double band that is conductive in the same way that a metal is conductive. When a small voltage or current is applied mobile electrons are added to the bands. When the bands become full enough that the coulomb repulsion becomes great enough, the partially filled bands split, with the filled p-orbital between them. This creates a filled band and an empty band separated by a significant energy, which is the band structure for a Mott-charge transfer insulator (See FIG. 14). When the electric field applied to the material becomes large enough to cause a transition between the split orbitals, electrons begin to jump from the lower band to the upper band, which reduces the coulomb repulsion, causing the correlated electron system to collapse back into the original state in which the orbitals overlap. The quantum mechanical transition can also be understood in terms of a Mott transition. In a Mott transition, a material switches from a paramagnetic conductive state to an anti-ferromagnetic insulative state when the Mott transition condition $(n_c)^{1/3}a = 0.26$ is reached, where $n_c$ is the concentration of electrons and "a" is the Bohr radius. This is sometimes explained as a "crowded elevator" phenomenon: when an elevator has only a few people in it, the people can move around easily, which is analogous to the conducting state, but when the elevator reaches a certain concentration of people, the people can no longer move, which is analogous to the insulative state. However, it should be understood that this classical explanation, like all classical explanations of quantum phenomenon, is only an incomplete analogy. In the Mott transition the spins of the electrons also play a significant role. In the paramagnetic state the spins disordered, while in the anti-ferromagnetic state the spins are anti-aligned; that is, the spins of electrons align in a regular pattern with neighboring spins pointing in opposite directions.

The preferred CEM materials according to the invention feature vacancy coordination passivation, and oxygen vacancy coordination passivation in particular. As known in the art, oxides, and transition metal oxides in particular, is densely populated with vacancies. The vacancy coordination sphere is the region about an ion or electron in which vacancies can affect the ion or electron. Vacancies within this vacancy coordination sphere can thermally detrap, and the electron can move to the vacancy site. This destabilizes the high resistance state. This is the principle reason for the instability of prior art variable resistance materials. In the materials according to the invention, the effect of the oxygen vacancies is cancelled, preferably by novel ligand structure of the Ce-RAM materials according to the invention.

As mentioned above, a feature of the preferred embodiment of the invention is the presence of extrinsic ligands that stabilize the CeRAM material. As known in the art, transition metal oxides include an intrinsic ligand, namely oxygen. An extrinsic ligand is a element or compound other than oxygen that participates in the coordination sphere of the transition metal ion. Preferably, the stabilization is via a direct metal-extrinsic ligand bond, though the bond of the extrinsic ligand may also be with an intrinsic ligand. Carbon is an example of an extrinsic ligand element, and ammonia is an example of an extrinsic ligand compound. Carbon is the preferred extrinsic ligand. All the best memory switching films made by the inventors, including all that crystallized in the ON state included an extrinsic ligand.

There are disclosed preferred methods for making CEMs and integrated circuits utilizing CEMs. In particular, chemical solution deposition (CSD) methods, preferably utilizing a metallorganic precursor, and most preferably, octane, are disclosed. Preferably, the chemical solution provides the element carbon. These methods preferably include a reaction in a gas containing the extrinsic ligand elements that stabilize the CEM or a gas containing the anion to which the ligand bonds, or both. The reaction may take place in an anneal process in a gas containing the ligand, the anion, or both. Or the reaction may take place in a reactive sputtering in a gas containing the ligand, the anion, or both.

The disclosure also includes novel preferred architectures for CEM memories, which architectures can also be applied to other variable resistance materials (VRMs), which includes chalcogenides, RRAM materials, and other materials. There is also disclosed preferred memory architectures and methods. These memory architectures and methods include a memory in which the memory element comprises a variable resistance material and a diode in series, which, in one embodiment, the memory element is read by measuring its capacitance. The memory architectures also include a variable resistance JFET in which a variable resistance material controls the current flow in and/or the voltage across the JFET channel.

The invention provides a resistive switching integrated circuit memory as recited in claim 1. Further embodiments are recited in claims 1 - 6 and 9.

The invention also provides a method of forming a resistive switching memory as recited in claim 7.

A further embodiment is recited in claim 8.

The invention provides denser memory arrays and faster program and erase cycles, such as by eliminating reliance upon hot carrier injection and Fowler-Nordheim tunneling from the silicon substrate as in the conventional Flash memory. Further, the invention provides a non-volatile memory with lower voltage program and erase cycles than prior art memories such as Flash, thereby enabling lower power operation. The invention also provides higher endurance of program and erase cycles, for example, by eliminating breakdown of gate oxide used as a tunneling oxide in Flash memory. The invention also provides continued scaling of the memory element, such as by eliminating programming via tunneling from the substrate and being affected by the deleterious aspects of shrinking channel length. Numerous other features, objects, and advantages of the invention will become apparent from the following description when read in conjunction with the accompanying drawings.

## BRIEF DESCRIPTION OF THE DRAWINGS

FIG. 1 shows the current in amperes versus bias voltage in volts curves for an NiO resistor according to the invention;

FIG. 2 is the same curves as shown in FIG. 1 except on a logarithmic scale which shows higher resolution at the smaller values of current;

FIG. 3 illustrates a silicon wafer with CEM "elements" comprising a CEM material according to the invention sandwiched between two electrodes;

FIG. 4 shows a cross-sectional view of one of the "elements" of FIG. 3 taken through the line 4-4 of FIG. 3;

FIG. 5 is a graph of voltage versus current illustrating the SET and RESET functions for an NiO element having a diameter of 50 microns;

FIG. 6 is a graph of voltage versus current illustrating the SET and RESET functions for an NiO element with the CEM material doped with 5% cobalt and having a diameter of 50 microns;

FIG. 7 show graphs of voltage versus current illustrating the SET and RESET functions for three NiO elements having different diameters illustrating how the memory window changes with element diameter;

FIG. 8 show graphs of voltage versus current in the high resistance state for four NiO sandwiches having different diameters;

FIG. 9 show graphs of voltage versus current density in the high resistance state for the four elements of FIG. 8;

FIG. 10 shows a graph of current in amps versus bias voltage in volts for the ON and OFF states after the NiO CEM was held at 150°C for five minutes;

FIG. 11 shows a graph of resistance in ohms versus temperature in degrees centigrade for the ON and OFF states illustrating the stability of these states at higher temperatures;

FIG. 12 shows an idealized current versus voltage curve for a resistive switching film with unipolar switching, illustrating the ON, OFF, RESET, and SET modes;

FIG. 13 is an illustration of the energy bands of a Mott-Hubbard insulator taken from *Introduction to the Electron Theory of Metals* by Uichiro Mizutani;

FIG. 14 is an illustration of the energy bands of a charge transfer type insulator taken from *Introduction to the Electron Theory of Metals* by Uichiro Mizutani;

FIG. 15 is a cross-sectional view of a M/CEM/M n-p diode switching cell;

FIG. 16 is an equivalent circuit diagram for the M/CEM/M p-n diode switching cell of FIG. 15;

FIG. 17 is cross-sectional view of a M/CEM/M-metal/semiconductor or Schottky diode switching cell according to the invention;

FIG. 18 is a cross-sectional view of a M/CEM/M-MESFET switching cell according to the invention;

FIG. 19 is a cross-sectional view of a M/CEM/M-JFET switching cell according to the invention;

FIG. 20 is an equivalent circuit diagram of the a M/CEM/M-JFET of FIG. 19;

FIG. 21 is a cross-sectional view of a MNRM/M-MOSFET switching cell according to the invention;

FIG. 22 is a cross-sectional view of a 1 transistor/1 resistor CEM switching cell according to the invention;

FIG. 23 is an equivalent circuit diagram of the 1 transistor/1 resistor CEM switching cell of FIG. 22;

FIG. 24 is a cross-sectional view of a M/VRM-MESFET switching transistor according to the invention in which the VRM forms a Schottky barrier with the semiconductor channel;

FIG. 25 illustrates the cross-sectional equivalent circuit diagram for a CEM memory in a cross-tie architecture;

FIG. 26 illustrates the cross-sectional equivalent circuit diagram for an alternative CEM memory in a cross-tie architecture;

FIG. 27 illustrates a chain cell architecture for a CEM memory according to the invention;

FIG. 28 illustrates a cross-sectional view showing the structure of one embodiment of a memory cell of the memory of FIG. 27;

FIG. 29 illustrates an exemplary memory utilizing any of the memory cells disclosed herein;

FIG. 30 is a graph comparing the voltage versus current curves for the diode portion of FIG. 15 and the SET and RESET functions of the switching cell of FIG. 15 with nickel oxide as the CEM;

FIG. 31 is a graph comparing the voltage versus current in the OFF and ON states for the switching cell of FIG. 30;

FIG. 32 is a graph comparing the capacitance versus voltage for the diode only portion of the structure of FIG. 15 and the M/CEM/M-diode switching cell of FIG. 15 with a nickel oxide CEM;

FIG. 33 is a graph comparing the dissipation versus voltage curves for the ON and OFF states of the switching cell of FIG. 15 and the diode only structure;

FIG. 34 is a graph comparing the voltage versus current curves for the JFET only portion of the structure of FIG. 19 with the and the SET and RESET functions of the switching cell of FIG. 19 with nickel oxide as the CEM;

FIG. 35 is a graph showing time versus voltage for voltage pulses applied to the gate and source of the switching cell of FIG. 19 with nickel oxide as the CEM;

FIG. 36 is a graph showing the measured voltage on the drain of the switching cell of FIG. 19 in response to the voltage pulses applied as show in FIG. 35;

FIG. 37 is a graph of the resistance of the CEM and parasitic resistance of the interconnects in series versus bias voltage for the SET and RESET states showing that high parasitic resistance will create an unstable condition;

FIG. 38 is a flow chart showing the process of fabricating the CEM "capacitors" of FIGS. 3 and 4;

FIG. 39 is an Arrhenius curve of the log of 1/Tau versus 1/T(1/K) for prior art sputtered NiO (without carbon) illustrating that the transition from the high resistance state to the low resistance state is caused by detrapping of electrons from oxygen vacancies in the sputtered NiO;

FIG. 40 shows a graph of Kelvin temperature versus resistance in Ohms for the ON and OFF states for a CEM thin film according to the invention and for a prior art thin film that crystallizes in the OFF state and requires forming before exhibiting variable resistance; and

FIG. 41 is a graph of number of reading cycles versus resistance in Ohms for the ON and OFF states for a CEM thin film according to the invention, demonstrating that there is little of no fatigue.

## DETAILED DESCRIPTION OF THE INVENTION

The present disclosure provides transition metal oxides as exemplary correlated electron materials (CEM), though the invention is applicable to other CEM materials as well. Nickel oxide, NiO, is disclosed as the exemplary transition metal oxide. The exemplary NiO materials discussed herein are doped with extrinsic ligands which stabilize the variable resistance properties. In general, this may be written as $NiO(L_x)$, where $L_x$ is a ligand element or compound and x indicates the number of units of the ligand for one unit of NiO- One skilled in the art can determine the value of x for any specific ligand and any specific combination of ligand with NiO or any other transition metal, simply by balancing valences. The preferred NiO variable resistance materials disclosed herein include at least a ligand containing carbon, which may indicated by $NiO(C_x)$.

The preferred variable resistance materials discussed herein are Correlated Electron Materials. A Correlated Electron Material (CEM) is a material that switches from a first resistive state to a second resistive state, with the second resistive state having a resistance at least one hundred times higher than the first resistance state, and the change in resistance is primarily due to correlations between the electrons. Preferably, the CEM material changes from a paramagnetic conductive state to an anti-ferromagnetic insulative state when the Mott transition condition $(n_c)^{1/3}a = 0.26$ is reached, where $n_c$ is the concentration of electrons and "a" is the Bohr radius. More preferably, the resistance of the second state is at least two hundred times the resistance of the first state, and most preferably, five hundred times. Generally, these materials include any transition metal oxide, such as charge exchange insulators. Several embodiments representing switching materials are nickel oxide, cobalt oxide, iron oxide, yttrium oxide, and perovskites such as Cr doped strontium titanate, lanthanum titanate, and the manganate family including praesydium calcium manganate and praesydium lanthanum manganate. In general, oxides incorporating elements with incomplete d and f orbital shells exhibit CEM resistive switching properties. Preferably, resistance can be changed by setting at one voltage and resetting at a second voltage. Preferably, no electroforming is required to prepare a CEM. The invention contemplates that many other transition metal compounds can be used in the invention. For example, {M (chxn)$_2$Br}Br$_2$ where M can be Pt, Pd, or Ni, and chxn is 1 R,2R-cyclohexanediamine, and other such metal complexes may be used.

It is a feature of the invention that the conduction of the CEM materials is area independent. That is because the conduction is a quantum mechanical phenomenon and is related to the transition probability through the film. This conduction, G, is given by:

$$G = (q^2 \rho_m \rho_{NiO}/hm)T,$$

where q is the electron charge, $\rho_m$, is the density of states in the electrode, $\rho_{NiO}$ is the density of states in the nickel oxide, m is the mass of the charge carrier, and T is the transmission probability through the film.

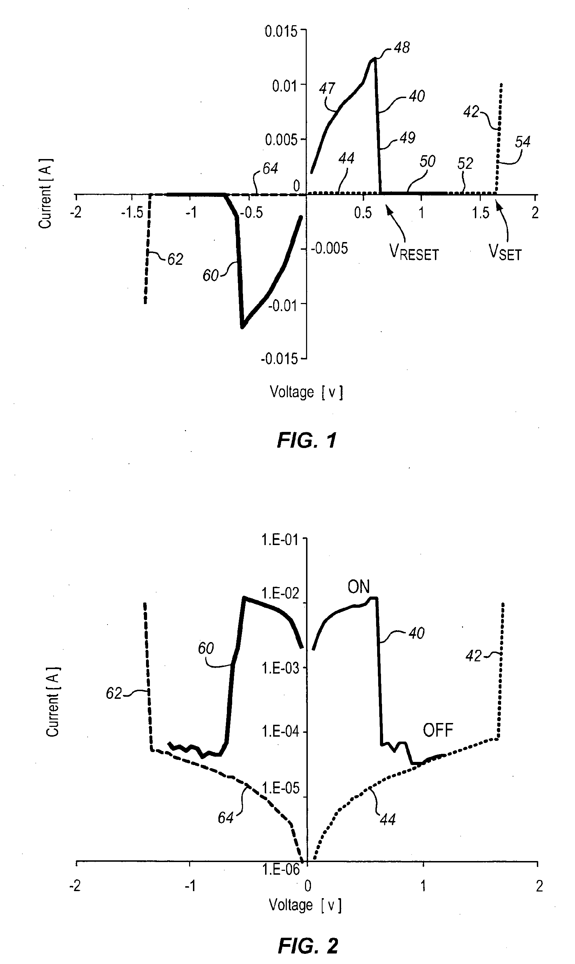

FIG. 1 shows the current in amperes (amps) versus bias voltage in volts curves for an $NiO(C_x)$ CEM according to the invention. FIG. 2 shows the same curves except the absolute value of the current is plotted logarithmically to show more detail in the low current values. As has become the nomenclature in the art, the point at which the CEM changes in resistance from a conductor to an insulator is called the RESET point, while the point at which the resistance changes from an insulator to a conductor is called the SET point. Unlike other variable resistance materials, the CEMs are crystallized in the conducting state. We shall refer to this as the ON state and the insulative state will be called the OFF state. The solid line 40 is the ON state curve for positive voltages and the solid line 60 is the ON curve for negative voltages. The dotted line 54 is the OFF curve for positive voltages, while the dotted line 62 is the OFF curve for negative voltages. As the voltage is increased, the current rises at 47, until the RESET voltage is reached, which is about 0.65 volts, which is also the point at which critical electron density is reached, then, at point 48 the material suddenly becomes insulative and the current drops sharply along curve 49. The current stays low along the line 52 as the voltage rises until the SET voltage is reached at about 1.65 volts, which corresponds to the Neel temperature for these materials, at which point the material again becomes conductive and the current rises along line 54. If the voltage is returned to zero and then raised again when the CEM is in the insulative state, the current follows the line 44, while if the voltage is returned to zero after the material becomes conducting, that is after the $V_{SET}$ point, the current follows the line 47. It is evident from FIGS. 1 and 2 that the write memory window exists between $V_{RESET}$ and $V_{SET}$, while the read memory window exists between the ON and OFF state current level. It is also evident from FIGS. 1 and 2 that these memory windows are easily large enough for a viable commercial memory. Thus, it can be seen that a CEM is a preferable VRM, though the architectures disclosed herein can be used with any variable resistance switching material.

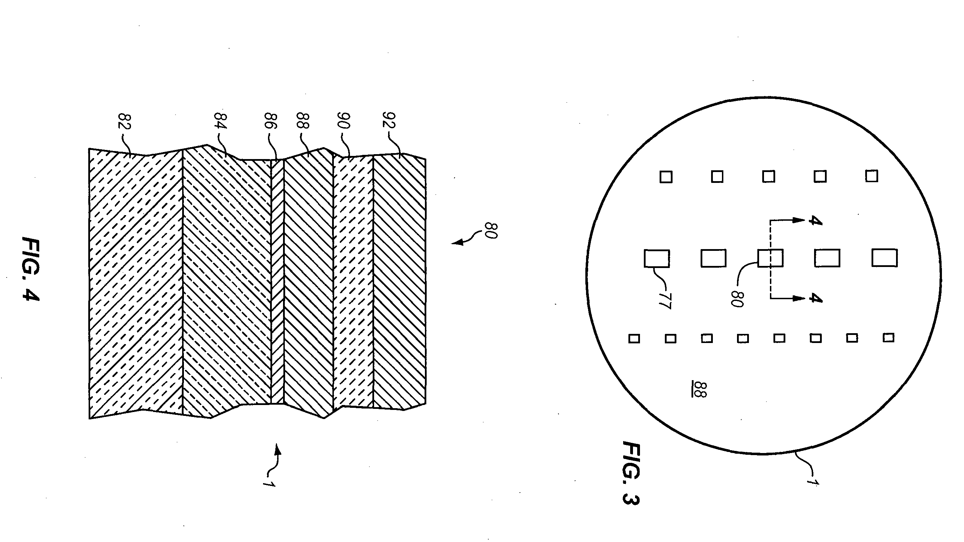

Turning now to FIGS. 3 and 4, a silicon wafer 1 having CEM integrated circuit elements, such as 77 and 80 formed on it is shown. FIG. 4 shows a cross-section through element 80 taken through line 4-4 of FIG. 3. Element 80 is formed on a silicon substrate 82 having a silicon dioxide coating 84. Optionally, a thin layer 86 of titanium or titanium oxide may be formed on oxide layer 84, though the elements reported on herein did not have such a layer. A layer 88, preferably of platinum, is formed on either layer 86 or directly on oxide layer 84. Layer 86 is an adhesion layer to assist the platinum in adhering to silicon dioxide layer 84. CEM material 90 is formed on platinum bottom electrode 88, preferably by a liquid deposition process, such as spin coating, misted deposition, CVD or atomic layer deposition. Then top electrode 92, preferably platinum, is formed on CEM layer 90. The elements 77, 80, etc. are then patterned by etching down to bottom electrode 88. The various elements 77, 88 can then be tested by attaching one probe to platinum surface 88 and touching a fine probe to the top electrode, such as 92, of the element to be tested, such as 80. The various curves discussed below were generated in this manner.

It should be understood that figures such as FIGS. 3, 4, 15, 17 - 19, 22 and 24 depicting integrated circuit devices are not meant to be actual plan or cross-sectional views of any particular portion of actual integrated circuit devices. In actual devices, the layers will not be as regular and the thicknesses may have different proportions. The various layers in actual devices often are curved and possess overlapping edges. The figures instead show idealized representations which are employed to explain more clearly and fully the method of the invention than would otherwise be possible. Also, the figures represent only one of innumerable variations of devices that could be fabricated using the designs and methods of the invention. As conventional in the art, the term "metal" when referring to an electrode or other wiring layer generally means a conductor. As known in the art, such "metal" electrodes and/or wiring layers can be made of polysilicon or other conductive material and are not necessarily made of metal.

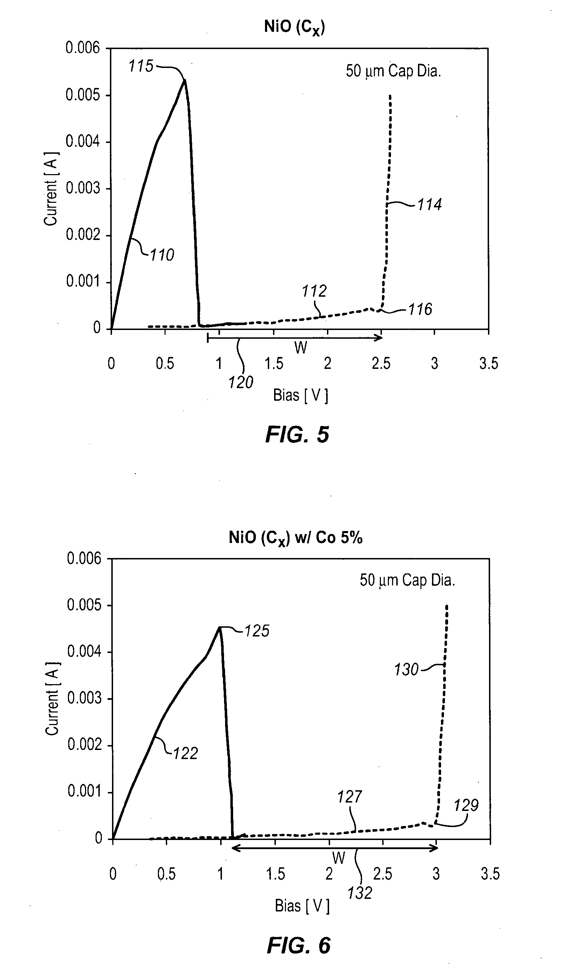

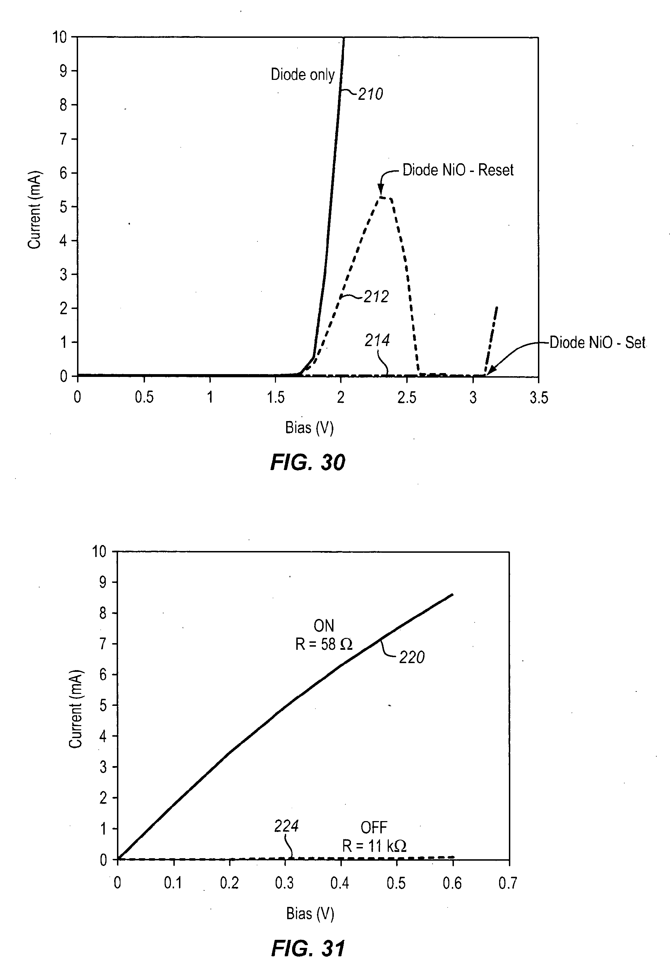

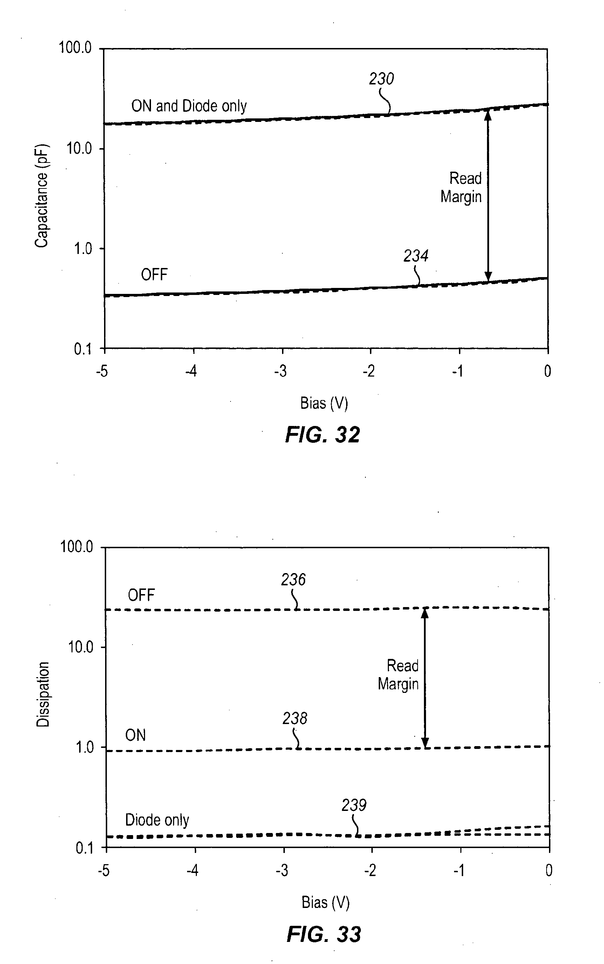

FIG. 5 is a graph of voltage versus current illustrating the SET and RESET functions for an NiO resistor having a diameter of 50 microns and FIG. 6 is a graph of voltage versus current illustrating the SET and RESET functions for an NiO capacitor doped with 5% cobalt and having a diameter of 50 microns. FIG. 5 is similar to the curve of FIG. 1 discussed above and is presented to facilitate comparison with FIG. 6. The general shape of the ON curves 110 and 122 and 114 and 130 remain essentially the same, as do the shape of the OFF curves 112 and 127. When comparing the curves of FIGS. 31 and 32, it is observed that the RESET point 115 of for the NiO$(C_x)$ CEM is at about 0.8 volts while the RESET point 125 of the CEM doped with cobalt is about 1.15 volts. Further, the SET point 116 for the NiO$(C_x)$ CEM is at about 2.5 volts while the SET point 129 of the CEM doped with cobalt is about 3 volts. Further, the width W of window 120 is about 1.75 volts while the width W of window 132 is about 1.85 volts. Thus, the onset of the insulative state has shifted, with the overall window W widening. These figures indicate that with selective doping, the onset of the states and the width of the voltage window can be adjusted.

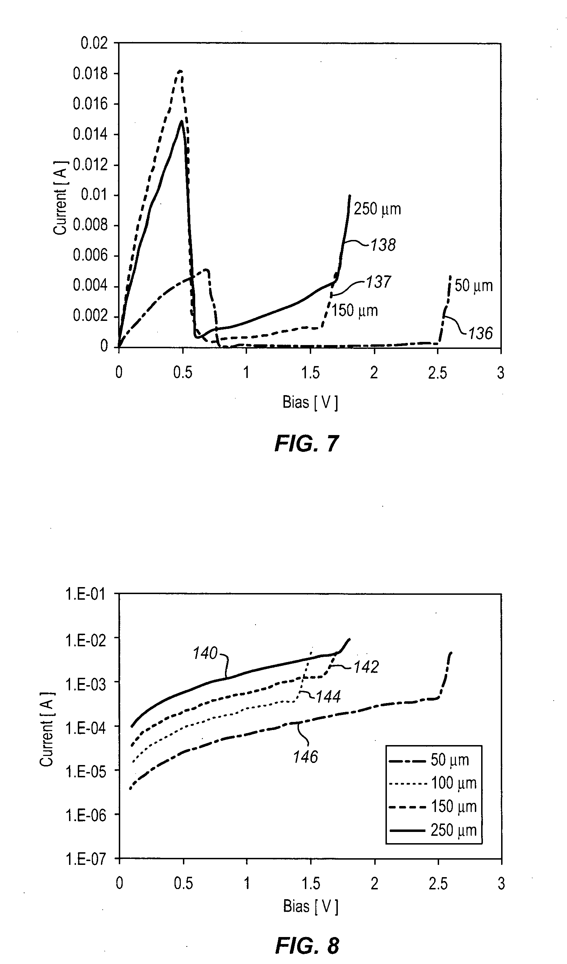

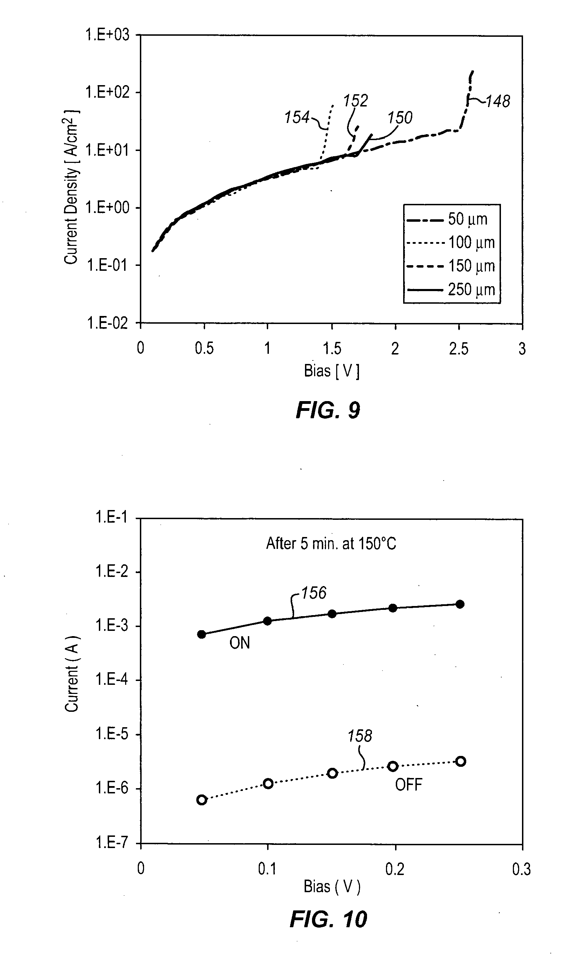

FIG. 7 show graphs 136, 137 and 138 of voltage versus current illustrating the SET and RESET functions for three NiO sandwich elements having diameters 0f 50 microns, 150 microns, and 250 microns, respectively, illustrating how the memory window changes with element diameter. FIG. 8 show graphs 140, 142, 144, and 146 of voltage versus current in the high resistance state for four NiO sandwich elements having diameters of 250 microns, 150 microns, 100 microns, and 50 microns, respectively, and FIG. 9 show graphs 148, 150, 152 and 154 of voltage versus current density in the high resistance state for the four elements, respectively, of FIG. 8.

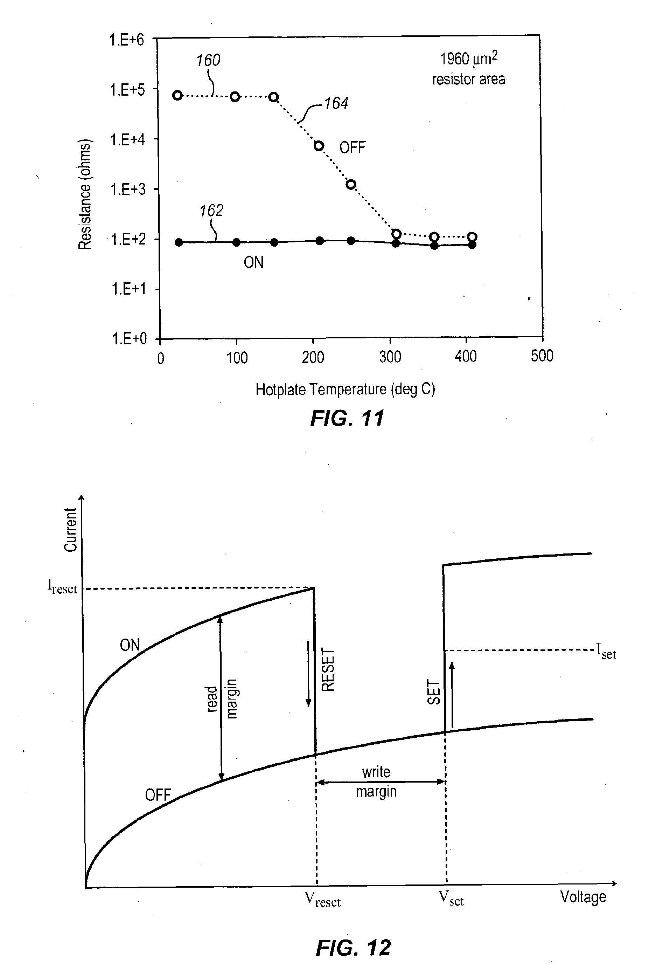

FIG. 10 shows a graph of current in amps versus bias voltage in volts after the NiO correlated electron material was held at 150°C for five minutes. This graph shows no degradation of the ON state 156 or OFF state 158 indicating the temperature stability of the resistance change phenomenon according to the invention. FIG. 11 shows a graph of resistance in ohms versus hotplate temperature in degrees C. To generate this curve, the CEM elements were placed on a hot plate and heated to the temperature shown. This graph shows that the OFF state 160 degrades above 150°C, as shown by the declining curve 164, but the ON state 162 did not degrade. Above 410°C, switching ability was not regained for the OFF state and was regained only with difficulty of the ON state. This graph demonstrates that memories made with the CEM material according to the invention should be stable at all reasonable temperatures.

FIG. 12 shows an idealized current versus voltage curve for a resistive switching film with unipolar switching, to better illustrate the ON, OFF, RESET, and SET modes. The material is crystallized in the ON state and the current rises along the ON curve as voltage is increased up $V_{RESET}$. The current then drops to the OFF curve and increases gradually along the OFF curve until $V_{SET}$ is reached, at which point it increases toward the ON curve. However, in devices, the current is limited the dotted line, $I_{set}$ to prevent overcurrent. The read and write margins are shown in the figure. As shown by FIGS. 6 and 7, the NiO$(C_x)$ films according to the invention follow these idealized curves better than any prior art material.

The CEMs are typically oxides formed from elements that have a partially filled 3d band and materials with partially filled 3f bands in the Periodic Table. The most well known of these oxides are vanadium oxide and nickel oxide. The materials with partially filled 3d bands or partially filled 3f bands are sometimes described also as Metal/Insulator phase transition materials. However, such metallic to insulator transition can also occur in combining transition metals with other materials of systems such as sulfides, iodines, tellurides, and others that do not involve oxygen. In all such materials, which includes groups IIIB up to and including group IIB (from column three to twelve across the Periodic Table - for half filled 3d materials) and the elements 57 to 71 and 89 to 103 for the half filled 3f band, clear description of the electronic bands is still lacking due to the strong coulombic correlation between electrons. However, the narrow 3d and narrow 3f orbitals cause strong electron correlations, and such correlations are responsible for a switching mechanism that can be voltage activated. For understanding the invention, it is important to separate this switching process which is triggered by a critical electron population from other switching processes, such as solid state phase changes. Herein, we shall refer to materials which employ the above-described switching process as "Correlated Electron Materials" (CEMs) and the basic unit of electrode/CEM/electrode as a "Mott-Bardeen Switch" (MBS). The easiest conceptual description of such materials is that in the insulating state the interaction energy between electrons is so strong that the effective mass (m*) is much heavier than the electron mass in the electron gas phase, which is known as the Rice-Brickman description. Thus, a switch between masses (caused by the overlap of the electron wave functions in 3d-subbands (or 3f-subbands) at a certain operational voltage sets the state of the material from insulator to metal (and vice-versa) by increasing or decreasing the interaction energy relative to the energy gap. In the past, such change in the electron mass was attained mainly by a change in temperature, and these materials were studied for their thermodynamic properties, implying a change in physical structure. However, as explained herein, the electronic transitions due to correlated electrons occur at room temperature or over a useful temperature region for device operation, and in both polarities of the applied voltage. Thus, when the term "phase change" is used herein with respect to a CEM, it relates to the change of an electronic phase. Also, the transition causes a hysteresis of the current versus voltage characteristic yielding two resistive states which are stable for an undetermined period of time producing a non-volatile memory behavior. Such memories are quite promising because they are not only non-volatile, but the electronic phase change is resistant to radiation damage and the memories can be made very dense.

A CEM with a single conducting electrode and the other surface contacted to an insulator or another CEM will be called "Metal/CEM Bardeen Barrier" or an "MCB barrier", better described by what is known in the literature as a "Bardeen Transfer Hamiltonian" which, when used with different effective mass tensors across the metal to CEM barrier, with or without the aid of vacancies, describes well the metal to CEM tunneling with an effective mass switch occurring as the electron enters the CEM from the common metal electrode, and an electronic phase transition is caused which produces the switching action; and when such an MCB barrier is in contact to a semiconducting material such as polysilicon which is a common floating gate material, this shall be called an "MCB to floating gate switch". These definitions will become useful as the complexities of the many embodiments of this invention are described below. Whether the theoretical descriptions are referring to a switch in effective mass or opening and closing of sub-bands in the density of states of the CEM, or the reaching of a critical electron density, the utility of the switching action and the stability of the final state (metal or insulating) and the control of such action is a central point of the invention for nan-volatile memories applications.

In the preferred CEM described herein, extrinsic ligand-forming dopants are added to the transition metal compounds.

The extrinsic ligands stabilize the metals in the compounds to a stable valence state. With such stabilization, electroforming is no longer necessary. Herein, stabilized means with respect to both time and temperature. In particular, it means that the electrical properties critical to reliable memory operation, including the RESET voltage, the SET voltage, and the memory window, i.e., the voltage or capacitance difference between the non-conducting and conducting states, does not change more than thirty percent over operational time period and temperature range, i.e., over a time period of three years, and more preferably, five years, and most preferably, ten years, and a temperature range from 0 °C to 60 °C, more preferably from -20 °C to 80 °C, and most preferably from -50 °C to 100 °C. More preferably, these electronic parameters do not change more then twenty-five percent, and most preferably, they do not change more than twenty percent.

Some ligands may be less useful than others because they are not stabilizing under all circumstances. Preferably, the invention utilizes ligands that stabilize the orbital valence states, and particularly the 3d orbital states. For example, the complex $[Ti(H_2O)_6]^{3+}$ is not stabilizing for conventional CMOS processing because when it is anneaied the water evaporates leaving uncompensated titanium, which can take many different valence states. Such a material will require electroforming. However, it can be stabilizing in other processes.

The preferred ligands comprise one or more elements selected from the group consisting of oxygen, hydrogen, fluorine, carbon, nitrogen, chlorine, bromine, sulphur, and iodine. Some useful ligands for various metals are shown in Table I, In this table, the metal of interest is given in bold, followed by the formula for the complex the metal forms with the ligand of interest.

Table I

**Aluminum**

$[Al(OH)_4]^-$

$[AlF_6]^{3-}$

**Cadmium**

$[Cd(CN)_4]^{2-}$

cis-$Cd(NH_3)_4Cl_2$

trans-$Cd(NH_3)_4Cl_2$

**Chromium**

$Cr(acac)_3$

$[Cr(CN)_6]^{4-}$

$[Cr(en)_3]^{3+}$

$[CrF_6]^{4-}$

$[Cr(NH_3)_6]^{3+}$

$[Cr(OH_2)_6]^{3+}$

$[CrO_4]^{2-}$

cis-$Cr(acac)_2(OH_2)_2$

trans-$Cr(acac)_2(OH_2)_2$

cis-$[Cr(NH_3)_4Cl_2]^+$

trans-$[Cr(NH_3)_4Cl_2]^+$

$[Cr(NH_3)_5Br]^{2+}$

$[Cr(NH_3)_5Cl]^{2+}$

$[Cr(NH_3)_5(OSO_3)]^+$

cis-$[Cr(OH_2)_4Cl_2]^+$

trans-$[Cr(OH_2)_4Cl_2]^+$

$[Cr(OH_2)_5Br]^{2+}$

$[Cr(OH_2)_5Cl]^{2+}$

$[Cr_2O_7]^{2-}$

**Cobalt**

$[CoBr_4]^{2-}$

$[CoBr_6]^{4-}$

$[CoCl_4]^{2-}$

$[Co(CN)_6]^{3-}$

$[Co(en)_3]^{3+}$

$[CoF_6]^{3-}$

$[Co(NH_3)_6]^{2+}$

$[Co(NH_3)_6]^{3+}$

$[Co(OH_2)_6]^{2+}$

$[Co(O_3C)_3]^{3-}$

Cis$[Co(en)_2Cl_2]^+$

trans-$[Co(en)_2Cl_2]^+$

cis-$[Co(OH_2)_4(SCN)_2]^+$

trans-$[Co(OH_2)_4(SCN)_2]^+$

cis-$[Co(NH_3)_4Cl_2]^+$

trans-$[Co(NH_3)_4Cl_2]^+$

cis-$Co(NH_3)_4(NO_2)_2$

trans-$Co(NH_3)_4(NO_2)_2$

cis-$Co(NH_3)_4(ONO)_2$

(continued)

**Cobalt**

trans-$Co(NH_3)_4(ONO)_2$

cis-$[Co(ox)_2(OH_2)_2]^-$

trans-$[Co(ox)_2(OH_2)_2]^-$

cis-$[Co(en)_2(NO_2)Cl]^+$

trans-$[Co(en)_2(NO_2)Cl]^+$

$[Co(NH_3)_5Cl]^{2+}$

$[Co(NH_3)_5(NO_2)]^{2+}$

cis-$[Co(NH_3)Br(en)_2]^{2+}$

trans-$[Co(NH_3)Br(en)_2]^{2+}$

**Copper**

$[Cu(CN)_2]^-$

$[Cu(NH_3)_4]^{2+}$

$[Cu(OH_2)_6]^{2+}$

cis-$[Cu(en)_2(OH_2)_2]^{2+}$

trans-$[Cu(en)_2(OH_2)_2]^+$

**Gold**

$[Au(CN)_2]^-$

**Iron**

$[Fe(Cl_4)]^-$

$[Fe(CN)_6]^{3-}$

$[Fe(CN)_6]^{4-}$

$Fe(CO)_5$

$[Fe(EDTA)]^{2-}$

$[Fe(en)_3]^{3+}$

$[Fe(OH_2)_6]^{2+}$

$[Fe(OH_2)_6]^{3+}$

$[fe(ox)_3]^{3-}$

$[Fe(SCN)_6]^{3-}$

cis-$[Fe(en)_2(NO_2)_2]^+$

trans-$[Fe(en)_2(NO_2)_2]^+$

$[Fe(OH)(OH_2)_5]^{2+}$

**Manganese**

$[MnCl_6]^{4-}$

$[Mn(CN)_6]^{3-}$

$[MN(CN)_6]^{4-}$

$[Mn(en)_3]^{2+}$

$[Mn(OH_2)_6]^{2+}$

$[MnO_4]^-$

**Mercury**

$[HgS_2]^{2-}$

$[HgCl_3]^-$

$[HgI_4]^{2-}$

**Molybdenum**

$[MoO_4]^{2-}$

**Nickel**

$[NiBr_4]^{2-}$

$[Ni(CN)_4]^{2-}$

$Ni(CO)_4$

$[Ni(en)_3]^{2+}$

$[Ni(NH_3)_4]^{2+}$

$[Ni(NH_3)_6]^{2+}$

$[Ni(OH_2)_6]^{2+}$

$[Ni(ox)_2]^{2-}$

$[Ni(penten)]^{2+}$

cis-$Ni(en)_2Cl_2$

trans-$Ni(en)_2Cl_2$

**Palladium**

$(PdCl_4)^{2-}$

**Platinum**

$[PtCl_4]^{2-}$

$[PtCl_6]^{2-}$

$[PtCl_6]^{4-}$

$[PtI_4]^{2-}$

$[PtI_6]^{2-}$

$[Pt(NH_3)_4]^{2+}$

$Pt(en)Cl_2$

cis-$Pt(NH_3)_2Cl_2$

trans-$Pt(NH_3)_2Cl_2$

cis-$Pt(NH_3)_2Cl_4$

trans-$Pt(NH_3)_2Cl_4$

$Pt(NH_3)_2(ox)$

$[Pt(NH_3)_3Br]^+$

trans-$[Pt(NH_3)_4Cl_2]^{2+}$

cis-$[Pt(NH_3)_4Cl_2]^{2+}$

cis-$[Pt(NH_3)_4I_2]^{2+}$

trans-$[Pt(NH_3)_4I_2]^{2+}$

**Rhenium**

$[ReO_4]^-$

**Rhodium**

$(RhCl_6)^{3-}$

$[RhI_2(CO)_2]^-$

cis$[Rh(phen)Cl_2]^+$

**Ruthenium**

$[Ru(NH_3)_6]^{2+}$

$[Ru(phen)_3]^{2+}$

$[Ru(NH_3)_5Cl]^{2+}$

**Silver**

$[Ag(S_2O_3)_2]^-$

$[Ag(NH_3)_2]^+$

**Tin**

$[SnCl_6]^{2-}$

$[Sn(OH)_6]^{2-}$

$[Sn(OH)_3]^-$

**Titanium**

$[TiO]^{2+}$

**Vanadium**

$[V(en)_3]^{3+}$

$[VO]^{2+}$

$[VO_2]^+$

$[VOCl_4]^{2-}$

**Zinc**

$[Zn(CN)_4]^{2-}$

$[Zn(NH_3)_4]^{2+}$

Based on the above discoveries, Applicants have for the first time applied ligand field theory to the understanding of a resistance switching mechanism in transition metal compounds. Ligand field theory was developed in the 1930's and 1940's as an extension of crystal field theory. See for example, "Ligand Field Theory" in Wikipedia, the free encyclopedia at http://en.wikipedia.org/wik/Ligand _field theory, which is incorporated by reference herein to the same extent as though fully disclosed herein. As explained therein, the energy difference between certain molecular orbitals (MO's) is called $\Delta_0$ where the "O" stands of octahedral. This size of this energy difference, $A_0$, determines the electronic structure of d orbitals. We have found that, in the thin-film regime used in the fabrication of the devices according to the invention, the stability of the memory window between the OFF state and the on state is substantially proportional to the stability of $\Delta_0$. Thus, the preferred dopant ligands are those which result in a large and stable $\Delta_0$. Some useful dopant ligands in descending order of the size of the $\Delta_0$ they create are: CO, $CN^-$, $PPh_3$, $NO_2^-$, phen (1,10-phenanthroline, biby (2,2'-bipyridine), en (enthylenediamine), $NH_3$, py (pyridine), $CH_3CN$, $NCS^-$, $H_2O$ $C_2O_4^{2-}$, $OH^-$, $F^-$, $N_3^-$, $NO_3^-$, $Cl^-$, $SCN^-$, $S^{2-}$, $Br^-$, and $I^-$. Theoretically, the crystal field splitting energy ($\Delta_0$) is not directly related to the Mott-charge transfer barrier or the Rice-Brickman mass. But, the stability of the metal-native ligand coordination sphere allows the electron-electron correlations inductive of these transitions to occur in a particular material as the nuances of the bonding and crystal structures are set in place. In any case, the technical relevant effect is to control or stabilize the oxidation number (or coordination sphere) in such a way the local stoichiometry is "nominal" or otherwise suitable to induce the necessary electron correlation conditions.

"Extrinsic ligand" or "dopant ligand" is defined herein to be the ligand material added to transition metal complexes to stabilize the multiple valence states of the transition metals. The ligand splits the d-orbitals. We use the term "extrinsic" or "dopant" because the ligand complex is an extrinsic material added to the lattice that is not intrinsic to the lattice structure of the transition metal compound. For example, in NiO, the oxygen is an intrinsic ligand, and $(CO)_4$, in forming $Ni(CO)_4$, is the extrinsic ligand. Similarly, other variants such $Ni_5(CO)_{12}$ (nickel carbonate) include a form of CO as extrinsic ligands to the basic NiO lattice. This is analogous to the use of the term dopant in semiconductor technology. That is, in semiconductor technology adding a dopant to silicon, for example, does not change the silicon so much that we refer to it as another compound. Likewise, the dopant ligand added to say, nickel oxide, does not change the fact that the material is nickel oxide. But, local correction of the many possible oxidation numbers (valences) of Ni, such as Ni vacancies, interstitials and oxygen vacancies that modify the nominal "+2" valence value, is achieved with ligands that mediate with the intrinsic ligand yielding a stable net oxidation number and eliminate the defect induced change in charge state.

The band structure of correlated electron materials according to the invention is complex and depends not only on the d-orbitals of the transition metals but also on the p-orbitals of the neighboring oxygen atoms. This is explained in detail in Introduction to the Electron Theory of Metals, Uichiro Mizutani, Cambridge University Press, Cambridge, UK, 2001, particularly pages 444 - 447. Figures 14.9(a) and 14.9(b) from page 446 of this book are reproduced herein at FIGS. 13 and 14. The $\Delta$ used in this section is different than the discussed above, so we shall refer to it as $\Delta_t$, since it is the charge transfer energy, i.e., the energy to transfer of 3d electrons to the oxygen atom. In these figures U is the d-orbital coulomb energy, sometimes referred to as the correlation energy, and $E_F$ is the Fermi level of the transition metal.

In both the Mott-Hubbard insulator of FIG. 13 and the charge transfer-type insulator of FIG. 14, when the density of electrons is small, U is small, and the d-orbitals 183, 192 and 184, 193 overlap forming a wide d band with few electrons, while the filled p-orbital 182, 191 is split from and below the d-band. The d-orbital thus behaves much like a metal, and the material is conducting. As the density of electrons becomes large, differences occur. When $\Delta_t$ is larger then U, as in FIG, 13, the d-orbitals split into a pair of separated bands 189 and 190, and the p-orbital 188 remains below the d-orbital bands.

When $\Delta_t$ is smaller than U, the p-orbital of the intrinsic ligand splits the d-orbital which tends to stabilize the d-orbital valence, yielding a net oxidation state of zero, for example, $Ni^{+2}O^{-2}$. In such conditions, the insulator is a charge-transfer insulator, which leads to lower operating voltages. Thus, correlated electron systems in which $\Delta_t < U$ are preferred systems. One way of understanding the resistive change of the CEM materials can be seen most easily using FIG. 14. As indicated above, when the density of electrons is small, the two d-orbital bands 192 and 193 overlap and a conductor results. As the density of electrons increases, it will reach a point where the coulomb repulsion is so high that the d-orbitals 194 and 195 split with the filled p-orbital valence band between them. One d-orbital 194 is essentially filled, while the other 196 is empty. It requires a large amount of energy for electrons to jump from the lower band 194 into the upper band 196. And, even if a d-d transition could occur with the aid of a hole in the p-orbital band, this requires a higher voltage, which is useful in the insulator to metal transition but not in the metal to insulator transition. Thus, this material will be an insulator with high resistance when the lower voltage induces a metal to insulator transition purely caused by increasing the local density of electrons. However, when the electric field created by the applied voltage becomes large enough, some electrons will begin to jump to the upper band 196. This creates an overlap of the upper empty band and lower filled d-bands, the condition of a highly conductive state with small coulomb repulsion, and the system collapses back to the state shown at the left in FIG. 14. From FIG. 14, it is also clear that transitions can be made from the p-orbital to the d-orbital which create "holes", which can be filled by electrons from filled d-bands. The interaction of d-d orbital transitions is highly dependent on the existence of p-orbitals in these CEM compounds. The absence of an oxygen atom in the lattice induces a +2 charge, i.e., a doubly charged vacancy, which would be neutralized if the oxygen would return with its -2 valence. Since this does not happen once the defect is in place, the Ni or other transition metal no longer coordinates or bonds normally with the oxygen, Thus, the emission of up to two electrons into this positive potential, makes the Ni become +4, with the result that it is no longer useful for a Mott or charge transfer condition. It is at this point that mediation between the defect and an extrinsic ligand, re-establishes the oxidation state of the nickel. Without the ligand, the unbalanced, unstable insulative state is either heavily saturated with coordination destroying oxygen vacancies or equally detrimental and related excess nickel anions in interstitial sites in the lattice.

The metal-ligand-anion (MLA) bond which stabilizes the correlated electron material in some embodiments can be formed in many ways. For example, it may be formed in an anneal or other reaction process. For example, the CEMs may be annealed in a gas that contains the ligand chemical element, the anion element, and preferably also includes both the ligand element and the anion. Any gas incorporating any of the ligands above may be used. The gas may be formed through conventional precursor vaporization processes, such as heating and bubbling. As another example, the CEM may be reactive sputtered in a gas containing the ligand chemical element, the anion or both. Again, any of the ligands above may be used. As an example, for NiO, with a carbon ligand and an oxygen anion, CO and $CO_2$ are possible annealing gases. The anneal may be performed with one or more of these gases, or may be performed in a mixture of an inert gas, such as argon or nitrogen, with the gas containing either the ligand element, the anion element, or both.

For additional understanding of ligand field theory and the related ligand chemistry, see An Introduction to Transition-Metal Chemistry: Ligand-Field Theory, Leslie E. Orgal, Methuen & Co. Ltd., London, 1960.

An alternative understanding of the resistive switching phenomenon can be obtained from Mott Insulator theory, as explained, for example, in Metal-Insulator Transitions, Sir Nevill Mott, Second Edition, Taylor & Francis, London, 1990, and the Hubbard Model, as explained, for example, in The Hubbard Model, Arianna Montorsi Ed., World Scientific, Singapore, 1992. This understanding can be briefly summarized by considering the basic voltage versus current curve showing the effect of the resistance switching on the current as the voltage is increased, as, for example, that shown in FIG. 5. At zero voltage, the NiO is in a paramagnetic phase, and has zero current. As the voltage is increased, the current rises in the region 110, due to the fact that the electric field is giving electrons enough energy to jump up into the conduction band. The number of electrons continue to increase until the Mott transition condition $(n_c)^{1/3}a = 0.26$, where $n_c$ is the concentration of electrons and a is the Bohr radius, is reached at point 115. As described by Mott, at this point the electron gas condenses and the material becomes an anti-ferromagnetic insulator. This is the RESET state. As the voltage continues to increase along line 112, there is a minor increase in current until the point 116 where the electric field energy becomes equal to what the thermal energy would be if the material was at the Neel temperature, which is about 550K for NiO. At this point, there is an electronic phase change of the material back to the paramagnetic state, which state remains even if the voltage is reduced back to the lower voltage range of portion of the curve. This is the SET state. In some modern theoretical approaches to this phase transition, the term "electron liquid" refers to the state of heavy mass and this "electron condensation" phenomenon, and, electron gas refers to the uncorrelated electron. Electron liquids, such as in the Landau theory of "Fermi-liquids" are still a very immature area of condensed matter physics and the term is used here only to describe highly correlated electrons, as in the liquid state, versus non interacting electrons as in the electron gas.

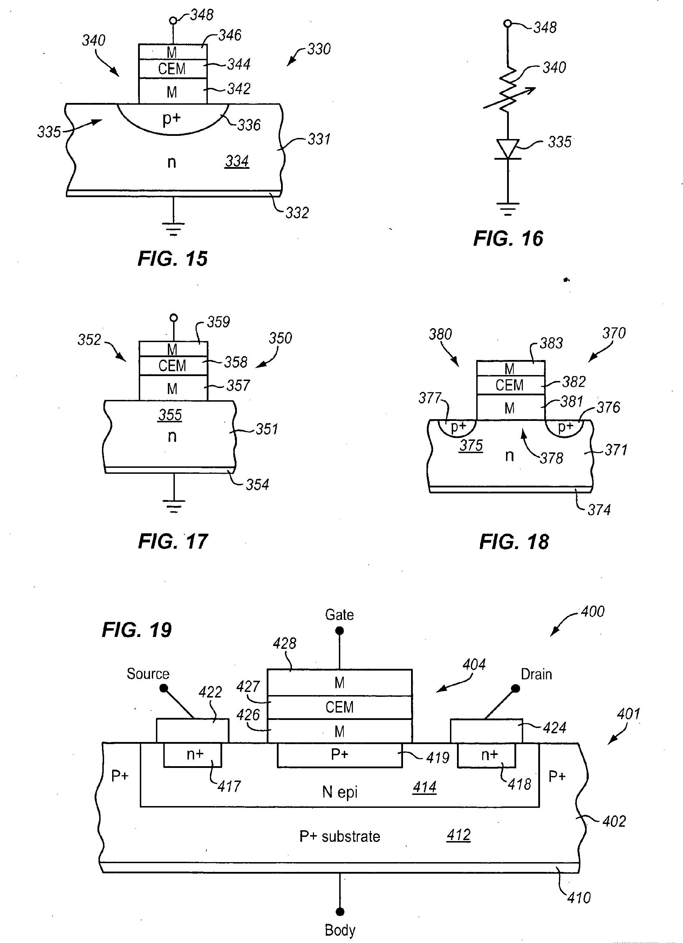

FIGS. 15 - 28 illustrate some of the non-volatile memories according to the invention. In this context, the word "substrate" can mean the underlying semiconductor material 82 (FIG. 4), 331, 351, etc. on which the integrated circuit is formed, as well as any object, such as layer 88 in FIG. 4 or layer 342 in FIG. 15, on which a thin film layer, such as 90 or 344, respectively, is deposited. In this disclosure, "substrate" shall generally mean the object to which the layer of interest is applied. For example, when we are talking about a thin film 90 of FIG. 4, the substrate on which it is initially deposited may include various elements, in particular, bottom electrode 88.

The long horizontal dimensions of substrates 82, 331, 351, etc. define planes that are considered to be a "horizontal" plane herein, and directions perpendicular to this plane are considered to be "vertical". The terms "lateral" or "laterally" refer to the direction of the flat plane of the semiconductor substrate, that is, parallel to the horizontal direction. Terms of orientation herein, such as "above", "top", "upper", "below", "bottom" and "lower", mean relative to substrate 82, 331, 351, etc. That is, if a second element is "above" a first element, it means it is farther from semiconductor substrate 82, 331, 351 etc.; and if it is "below" another element, then it is closer to semiconductor substrate 82, 331, 351, etc. than the other element. Terms such as "above", "below" or "on" do not, by themselves, signify direct contact. However, terms such as "directly on" or "onto" do signify direct contact of one layer with an underlying layer. However, "directly above" does not require direct contact, but rather means that if a line is drawn perpendicular to the underlying substrate and the line passes through the first element, it also will pass through the second element. It is understood that thin films of CEM fabricated in accordance with the invention have various shapes and conform to various topographies and features of an integrated circuit substrate. Accordingly, thin films of CEM in accordance with the invention are formed on planar substrates, in trenches and vias, on vertical sidewalls, and in other various non-horizontal and three-dimensional shapes.

The term "thin film" is used herein as it is used in the integrated circuit art. Generally, it means a film of less than a micron in thickness. The thin films disclosed herein are typically less than 500 nanometers (nm) in thickness. A thin film of correlated electron material fabricated by a method in accordance with the invention typically has a final thickness in a range of about from 20 nm to 300 nm, preferably in a range of about from 25 nm to 150 nm. The thin films having a thickness of about 60 nm or less are specifically designated "ultra-thin films" in this specification.

FIG. 15 is a cross-sectional view of a M/CEM/M n-p diode switching cell 330. FIG. 16 is an equivalent circuit diagram for the M/CEM/M p-n diode switching cell of FIG. 15. Cell 330 is formed on a semiconductor wafer, which is preferably silicon, but also may be gallium arsenide, germanium, silicon-on-insulator (SOI), or any other suitable semiconducting substrate, Wafer 331 preferably includes an isolation layer 332, an n-type region 334, a p+ active area 336, and a metal/CEM/Metal electronic phase change device 340 formed on active area 336. N-type region 334 and p+ active area 336 form a n-p junction diode 335. Device 340 includes a bottom electrode 342, a CEM layer 344, and a top electrode 348. Electronic phase change device 340 is preferably part of a cross-tie structure.

FIG. 17 is cross-sectional view of an M/CEM/M-metal/semiconductor or Schottky diode switching cell 350 according to the invention. Cell 350 comprises a Metal/CEM/Metal switching element 352 fabricated on a semiconductor wafer 351. Wafer 351 includes isolation layer 354 and n-type doped area 355. Variable resistance element 352 comprises a lower electrode 357, a CEM layer 355, and a top electrode 359. The Schottky diode is formed at the interface of the n-type area 355 and electrode 357. Variable resistance device 352 is preferably part of a cross-tie structure.

FIG. 18 is a cross-sectional view of an M/CEM/M-MESFET 370 according to the invention. Cell 370 is essentially an MESFET in which a CEM variable resistance element 380 is the gate of the MESFET 370. Cell 370 comprises a Metal /CEM/Metal switching element 380 fabricated on a semiconductor wafer 371, which is preferably gallium arsenide, but may also be germanium, silicon, or any other suitable semiconductor. Wafer 371 includes isolation layer 374, n-type doped area 375 including channel 378, and p+ type active areas 376 and 377. Variable resistance switching element 380 comprises a lower electrode 381, a CEM layer 382, and a top electrode 383. Variable resistance device 380 is preferably part of a cross-tie structure.

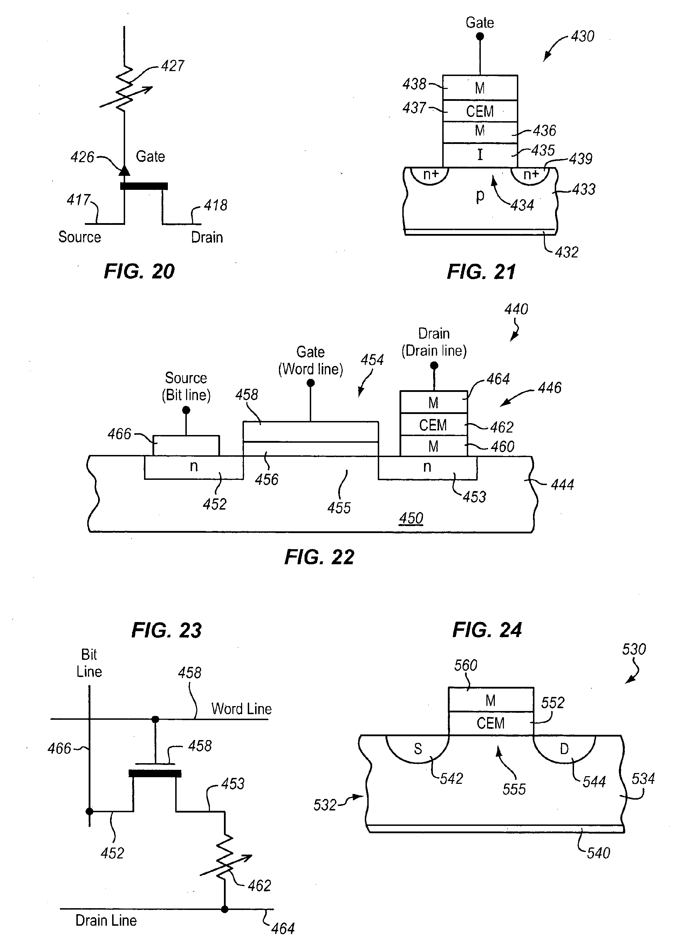

FIG. 19 is a cross-sectional view of a M/CEM/M-JFET memory switching cell 400 according to the invention, and FIG. 20 is an equivalent circuit diagram of the a M/CEM/M-JFET 400 of FIG. 19. This structure is essentially a JEFET in which a variable resistance switching element 404 forms one side of the JFET gate. M/CEM/M-JFET 400 is formed on semiconductor wafer 401 comprising a backside gate contact layer 410, a p+ substrate, and n-type region 414, which is preferably an epitaxial layer. N+ active areas 417 and 418 and p+ region 419 are formed in n-type region 414. Metallization contacts 422 and 422 are formed on active regions 417 and 518, respectively. Metal layer 426, CEM 427, and metal layer 425 are formed over p+ region 419.

FIG. 21 is a cross-sectional view of a M/VRM/M-MNOSFET memory switching cell 430 according to the invention. Device 430 comprises a p-type semiconductor 433 on an isolation layer 432, n+ active areas 439, and gate stack 434. Gate stack 434 includes insulator 435, which is preferably silicon dioxide, conductive gate 436, VRM layer 437, and top electrode 438.

FIG. 22 is a cross-sectional view of a 1 transistor/1 resistor CEM switching cell 440 according to the invention, and FIG. 23 is an equivalent circuit diagram of the 1 transistor/1 resistor CEM switching cell of FIG. 22. Cell 440 is formed on semiconductor wafer 444, which is preferably p-type silicon, but may be any other semiconductor. N-type active areas 452 and 453 are formed in wafer 444 and gate insulator 456 and gate 458 are formed over channel region 455 between the active areas as in conventional CMOS structures. A CEM device 446 is formed on one active area 453 and a metallization contact layer 466 is formed on the other active area. CEM device comprises bottom electrode 460, CEM layer 462, and top electrode 464. While this structure is similar to 1T/1C DRAM and ferroelectric memory structures, CEM layer 462 does not store charge but rather switches resistance states. The resistance state can be identified by the voltage drop across the CEM device 446.

FIG. 24 is a cross-sectional view of a M/I/S switching transistor 530 according to the invention in which the insulator is a CEM, that is, a metal/VRM/Semiconductor switch. M/CEM/S switch 530 is formed on a semiconductor wafer 532, which is preferably silicon but may be any other suitable semiconductor. An isolation layer 540 is formed at the bottom of the wafer, and either a p-type or n-type region 534 forms the channel region 555, on either side of which are implants 542 and 544 which form active regions. A CEM layer 552 is formed on channel 555 and a metal layer 560 is then formed on CEM layer 552.

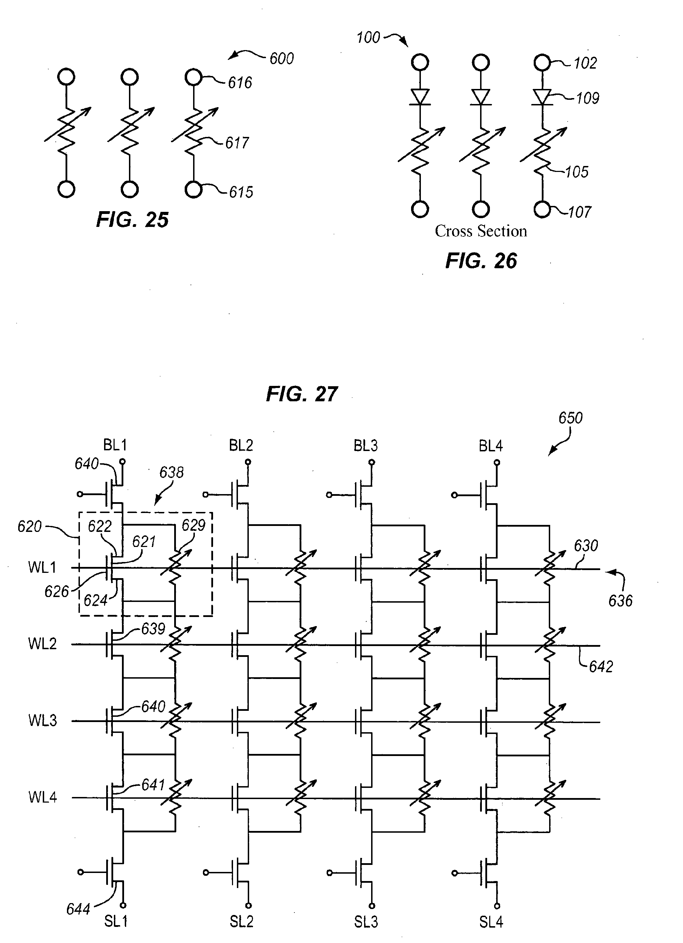

A basic CEM cross-tie array is shown in FIG. 25. FIG. 25 illustrates the cross-sectional equivalent circuit diagram for a CEM memory in a cross-tie architecture. In the cross-tie architecture, first conducting lines 616 running in a first direction form a cross-tie with second conducting lines 615 running in second direction, which second direction is preferably perpendicular to the first direction. At each point where the lines cross, a memory cell, is formed. In the simplest cross tie memory shown in FIGS. 25 and 25, a CEM layer, such as 617, is sandwiched between the conductors 615 and 616. This memory is preferably operated by setting all cells to the conducting state, they writing selected cells to the insulating state. For example, if the reset voltage is 1 volt, CEM element 617 may be reset to an insulating state by placing ½ volt on line 616 and ½ volt on line 615. The other lines are held at zero volts. The non-selected CEM elements, such as 617, will not be reset because the voltage placed on them will always be less than the reset voltage. Individual cells may be read by placing a small read voltage across the lines corresponding to that cell and holding all other lines in the open state. If the selected cell is conducting, there will be much less of a voltage drop across it than if it is insulating. The state of the cell can thus be read by sense amplifiers know in the art. While this simple cell structure preferably is operated using a block erase, other cross tie cell architectures using a CEM that are true random access memories for both write and read, will be discussed below.

FIG. 26 illustrates another cross-tie memory 100 according to the invention having a CEM layer 105 between cross-tie electrodes 102 and 107. This is the same as the memory 600 of FIG. 25 except that a Schottky diode 109 is formed at the intersection of CEM layer 105 and top electrode 102.

FIG. 27 illustrates a chain cell CEM memory array 650 according to the principles of the present invention. The memory array 650 is composed of memory cells, such as 120, that include a CEM memory element 629 connected in parallel with a switch 621. In one embodiment, the switch 621 may be a MOS transistor. Alternatively, other types of transistors may be utilized. The memory array 650 may be configured by forming series or chains 638 of memory cells 620. As shown, the chains of memory cells 620 may be connected along bit lines BL1-BL4. Word lines WL1-WL4, such as 630, may be connected to memory cells via gate terminals, such as 626, of the switches along a row 636 of memory cells 620. Each bit line may have a select switch, such as 640, and sense switch, such as 644, connected thereto used to control access to memory cells 620 along the corresponding bit lines BL1-BL4. For example, to access a memory cell 620 having switch 621, select switch 640 and control switch 644 are selectably turned on. Below each control switch, such as 644, may be a sense amplifier SL1-SL4 that is used for reading data stored in the memory cells along the corresponding bit line as understood in the art.

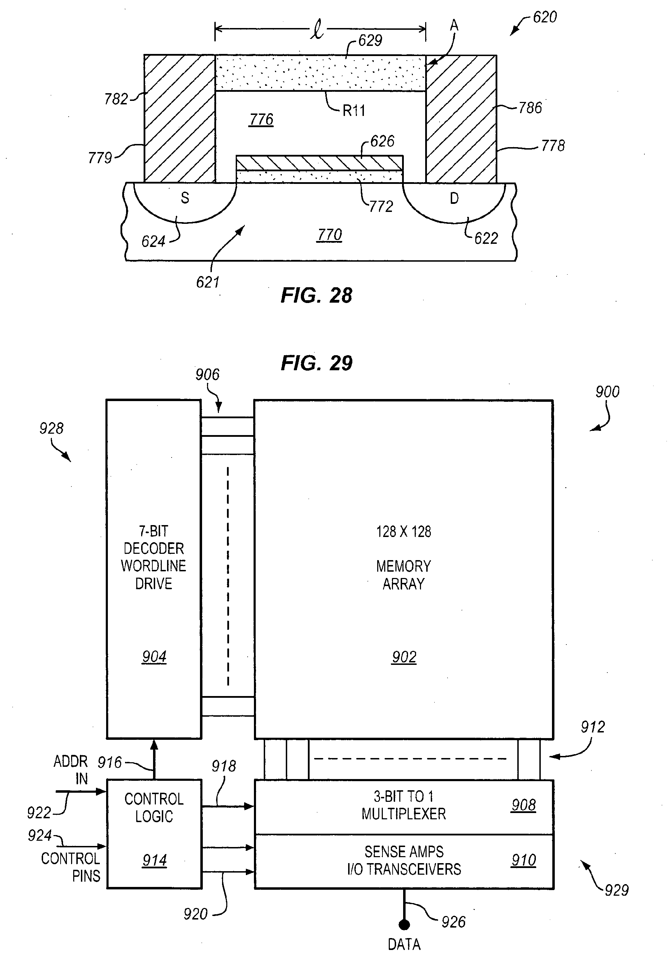

FIG. 28 is a cross-sectional view showing the preferred physical structure of a memory cell 620 in the chain cell memory array 650 of FIG. 27. This physical structure may also be used for other memories having memory cell including a transistor and a resistor. Memory cell 620 includes transistor 621 and phase change resistor 629. Transistor 629 comprises semiconductor 770, preferably silicon, having doped source active region 624 and doped drain active region 622, silicon oxide layer 772 and gate 626, preferably, polysilicon. An interlayer dielectric 776 covers transistor 621. Vias 778 and 779 are formed in interlayer oxide 776 and filled with metallization to form posts 782 and 786, which serve as electrodes. A thin CEM layer 629 is deposited to connect posts 782 and 786. As known in the art, the resistance R of element 629 is R= ρl/A, where ρ is the resistivity, l is the length of the CEM element as shown in FIG. 28, and A is the area of the CEM element perpendicular to the current flow. As shown in FIG. 28, A is very small, equal the thickness of layer 629 times its width into the paper. Since the thickness can be extremely small and controlled quite precisely, the resistance in this structure easily can be made large and controlled. The structure of FIG. 28 also makes it easy to link together the chain cells of FIG. 27, with the drain of one transistor 621 sharing the same doped region as the source of the next transistor 639, and the posts 782 and 786 serving double duty as the posts for the neighboring cells as well. Preferably, element 629 is a CEM, but may be any material with a variable resistance.

As previously described, the switches, such as 640 and 644 at the top and bottom, respectively, of the bit lines BL1-BL4 are row/column select switches and sense switches, respectively. The select switches 640 and sense switches 644 are used to select a certain bit and to separate the memory array 650 from extrinsic circuitry. For example, if memory cell 620 is to be selected, select switch 640 and sense switch 644 are turned on and the other select and sense switches are turned off. In addition, word line 630 is grounded, i.e., signal WL1 is made zero, and each of the other word line signals WL2, WL3, and WL4 are turned high. By applying a low voltage onto word line WL1, switch 621 remains or is turned off so that current is forced through element 629 connected in parallel to switch 621. Because word lines signals WL2, WL3, and WL4 are high, each of the corresponding switches 639, 640, and 641, are turned on such that current flows through the switches and bypasses each of the other resistive elements, respectively, connected in parallel. The process of being able to select one memory cell along a bit line enables random access writing and reading. While not writing to or reading from the memory array 650, select switches, such as 640, and sense switches, such as 644, may be turned off so that memory array 650 is isolated from the extrinsic circuitry, thereby keeping electrical noise from memory array 650. It should be understood that memory array 650 is shown as a 4x4 chain array, and may be sized and dimensioned as desired, such as 128x128 or much larger.

FIG. 29 is a block diagram of a memory circuit 900 including an exemplary electronic phase change memory array 902 according to the principles of the present invention connected to write and read circuitry. The memory cells in phase change memory array 902 may be any of the memory cells described above. In one embodiment, phase change memory array 902 is formed of 128x128 memory cells. However, variable resistance memory array 902, preferably an electronic phase change memory array, may have virtually any size as understood in the art. Variable resistance memory array 902 may be connected to a 7-bit decoder word line drive circuit 904 via word lines 906. Memory array 902 may be further coupled to a 3-to-1 bit multiplexer 908 and sense amplifiers/input-output transistors 910 via bit lines 912. Control logic circuitry 914 may be in communication with (i) the decoder 904 via control lines 916, (ii) multiplexer 908 via control lines 918, and (iii) sense amplifier 910 via control lines 920. Extrinsic input lines may include an address input line 922 and control lines 924. A data output line 926 may be used to output data from memory circuit 900 via sense amplifiers/transceivers 910.

In operation, an extrinsic processor may be used to drive the control logic 914. Control logic circuitry 914 communicates with decoder 904, multiplexer 908, and sense amplifiers 910, which, in combination, are used to write data into phase change memory array 902 and read data stored in phase change memory array 902. Control logic 914 and decoder 904 comprise a write circuit 928 for placing the resistive switching memory cell in a first resistive state or a second resistive state depending on information input into the memory, and control logic 914, multiplexer 908, and sense amps 910 comprise a read circuit 929 for sensing the state of the memory cell and providing and electrical signal corresponding to the sensed state of the memory cell. As known in the art, the first resistance state may correspond to a logic "0" state and the second resistance state may correspond to a logic "1" state, or vice versa. Herein, for convenience, we have referred to the first resistance state as the ON or low resistance state and the second resistance state as the OFF or high resistance state.

The correlated electron resistance switching material is particularly suited for memories, preferably non-volatile memories. A wide variety of such memories are possible, some of which have been discussed above.

Since a CEM retains the resistance state it is place in indefinitely with no voltage or electric field applied to it, all of the CEM devices described herein are inherently non-volatile switching devices. As known in the art, non-volatile switching devices can be used as or in non-volatile memories. Thus, all of the devices described above also comprise a non-volatile memory cell, or cells in the case of the structures which show multiple CEM elements. Thus, it should be understood that whether the device has been referred to as a CEM layer, a switch, a switching cell, a memory cell or a memory in the above discussion, has been determined by the context, and in all cases the other terms apply also.

All of the above cells are written to by applying either a SET or RESET voltage between the bottom and top electrodes, or in the case of the device of FIG. 16, across the electrodes 682 and 686, or in the case of the device 530 of FIG. 12, or between the upper electrode 560 and one or more of the source 542, the drain, 544, and the semiconductor 534. The devices having a VRM stack located over a channel are read by controlling the conductivity of the channel with the state of the VRM material. For example, in the 370 of FIG. 6, if a read voltage is applied to the upper electrode 383, the voltage on the lower electrode 381 will be higher if VRM 382 is conducting, and lower if VRM 382 is high resistive. This difference in voltage on bottom electrode 381 will result in a different conductivity of channel 378, which can be read by applying a voltage across source 377 and drain 376 and reading the resistance, a voltage, or a current. The CEM switching cell 440 of FIG. 10 can be read similarly to a ferroelectric or DRAM memory, using the select transistor 454 to select the cell to be read or written. A voltage or current is placed across the cells, and the resistance state of the CEM determines the voltage or charge developed across the cell, and by sense amplifiers 910. It is evident that if the CEM is conductive, the voltage drop across the CEM will be much smaller than the voltage drop when the CEM is insulating. It is evident that this read can be described in terms of reading a resistance, a voltage, or a current. That is, referring to FIG. 1, if a read voltage of, say about 0.3 volts, is place across the cell, there will be a large resistance, voltage, or current difference between a cell that is in the state represented by curve 47 and a cell that is in the state represented by the curve 44. In any description, it is evident that the read is inherently non-destructive because the read voltage is well below $V_{RESET}$ and $V_{SET}$.

The variable resistance - diode configuration, such as shown in FIG. 15, and the variable resistance-JFET configuration, such as shown in FIG. 19, provide important advantages for memory operation. In the variable resistor-diode architecture, the one-way current flow action of the diode introduces an asymmetry in the I-V hysteresis. Under reverse bias, the diode only allows a small reverse saturation current, in approximately the uAmp range, to flow. The current flow is small and almost all voltage potential drops across the diode, which is a further feature that prevents switching of the variable resistance. Hence, the reverse bias hysteresis traces are flat. Under forward bias conditions, the diode starts to flow current at the diode turn on voltage. Above the turn on voltage, the diode is behaving more or less as a short, thus switching of the variable resistance takes place normally. The main result in the hysteresis curves under forward bias is that they are offset by the built-in potential of the diode. The importance of this configuration is that we can now switch the variable resistance element normally under forward bias for writing the memory state. We can also apply reverse bias and not worry about disturbing the memory state. This reverse bias condition is useful to perform a non-destructive read out (NDRO). This may be done by measuring the depletion capacitance of the reverse-biased diode. Before getting to the NDRO of the variable resistance-diode architecture, it is helpful to review the capacitance-voltage characteristics of a stand alone diode first. Under reverse bias conditions, there is a layer at the interface of the pn junction that is depleted of free carriers. This is the called the depletion layer. The depletion layer gets wider under larger biasing, while it gets thinner under smaller biasing. The depletion layer can be considered as a parallel plate capacitor with the width of the depletion layer being the spacing between the plates. Hence, the capacitance of the diode will be smaller at large reverse bias and larger at small reverse bias. This capacitance can be measured by superimposing a high frequency AC signal on top of the static reverse bias voltage. Now consider the variable resistor in series with the diode. When the variable resistor is in the ON (low resistance) state, there is not much effect to the C-V curves as the variable resistance only introduces a small series resistance. However, when the variable resistance is in the OFF (high resistance) state, there is a significant series resistance and capacitance. These series components reduce the overall measured depletion layer capacitance. In this way, the resistance state of the variable resistance element can be determined from the measured capacitance. The read process is very different from the usual read process for memories because a capacitance is measured rather than a voltage or current. However, it should be understood that read processes as discussed above, that include a measurement of resistance, voltage or current, are a preferred method of reading.

Write operation of the CeRAM-JFET, such as shown in FIG. 19, is similar to the write operation of the CeRAM-diode. The gate is forward biased with respect to the drain (or source) line. The gate stack of the CeRAM-JFET has the same architecture and equivalent circuit as the CeRAM-diode configuration. Unlike a MOSFET, where the gate oxide prevents any current flow, the gate of the JFET can be forward biased to flow current for writing the resistive state.

For the read operation, the depletion region created by the JFET gate stack is directly responsible for modulating the conductivity between the source and drain. As gate reverse bias is increased, the depletion region extends into the channel region and reduces the source-drain conductivity. In the limiting case, the channel becomes completely "pinched off" and the JFET is OFF. In a sense, the CeRAM-JFET is similar to a FLASH structure. FLASH is a single transistor that uses a gate stack that is able to store a static charge which thereby modifies the channel conductance. The CeRAM-JFET is also a single transistor that uses a variable resistor in the gate stack as a programmable voltage divider. By turning the variable resistor off, part of the gate bias is dropped on the variable resistor, which reduces the bias level applied to the JFET gate. This in turn increases the source-drain conductivity. The major difference between the FLASH and CeRAM-JFET devices is that the control charge on the FLASH gate is static, while the voltage dividing behavior of the CeRAM-JFET is dynamic and determined by the RC constant of the gate stack. Read operation of the CeRAM-JFET is thereby accomplished through the transient response of voltage pulses. A pulse is applied simultaneously to the gate and the source. These pulses need to be in opposite polarities to keep the gate reverse biased. The measured voltage on the drain line yields the memory state of the variable resistor. For the variable resistor ON state, the entire gate pulse is dropped on the JFET gate and the JFET channel is pinched off. This results in a lower channel conductivity and a lower voltage on the drain line. For the variable resistance OFF state, only part of the gate bias pulse is dropped on the JFET gate. The resulting source-drain conductance is higher, and a larger drain voltage is measured.

With proper design, the MOSFET with a VRM on the gate device 430 shown in FIG. 9 may be used in place of the JFET-VRM scheme described above. While, as mentioned above, the MOSFET gate oxide 435 prevents DC current flow through the VRM 437, the RC characteristic of the VRM/MOS gate stack 434 allow for a transient current/voltage response that is sufficient to switch the VRM during pulsing. By proper scaling of the VRM and gate oxide thickness and area, the MOS capacitance and the VRM resistance can be engineered to permit a write function that switches the VRM material 437. Writing to the VRM is thus accomplished even though no direct current can flow through the gate stack. Readout of the MOSFET-VRM circuit is performed by the same method as the JFET-VRM read function described above.

Those skilled in the art will recognize that in the memory structures above which utilize n and/or p doping, the n and p dopings can be interchanged.

FIG. 30 is a graph comparing the voltage versus current curves for the diode portion of FIG. 15 and the SET and RESET functions of the M/CEM/M-diode switching cell 330 of FIG. 15 with nickel oxide as the CEM. The diode curve is at 210, the ON curve which leads into the RESET function is at 212, and the OFF curve that leads into the SET function is at 214. As known in the art, when the diode is forward biased, the device does not conduct until a threshold is reached and then the current rises exponentially. With the CEM device formed over the diode, the current is essentially zero up to the threshold voltage, due to the action of the diode, then rises, but not quite so quickly, due to the resistance of the CEM layer. The threshold voltage is about 1.7 for this diode. At about 2.3 volts, the current begins to drop and becomes essentially zero at about 2.6 volts, as the resistance has greatly increased. Then, at about 3.1 volts, the current again increases, indicating the CEM material has switched back to a low resistance state. If the voltage is lowered, the current will follow the ON curve. A feature of M/CEM/M-diode device 330 is that resistive switching occurs only when the diode is forward biased. Reverse bias prohibits switching. This is a significant improvement over the prior art as this feature prevents disturb in a cross-tie memory.

FIG. 31 is a graph comparing the voltage versus current in the OFF and ON states for the M/CEM/M-diode switching cell of FIG. 15 with a nickel oxide - carbon CEM. FIG. 32 compares the capacitance versus voltage curves for the ON and OFF states and for the diode only, and FIG. 33 compares the dissipation versus voltage for the ON and OFF states. As can be seen from FIG. 31, the resistivity in the OFF state is 11 kOhms, while it is only 58 ohms in the ON state. As a result, the current in the ON state can easily be differentiated from that in the OFF state, with just a small applied voltage, such as 0.5 volts. Thus, the memory window is very large. From FIG. 32, the read margin is over 300 picofarads. In the ON or low resistance state, the voltage is primarily dropped across the reverse bias diode. This is a depletion capacitance state. The capacitance as shown in FIG. 32 and the dissipation as shown in FIG. 33 are similar to the same quantities in the diode only. In the OFF or high resistance state, the voltage is partially dropped across the CEM resistor, and the dissipation increases according to tan (d) = $\omega RC$. Because the state of the switch or memory can be read with a voltage much lower than the RESET or SET voltage, and unless the RESET of SET voltage is reached, the system always remains in the same state, the M/CEM/M-diode switching cell permits the fabrication of a no-disturb, non-destructive readout memory.

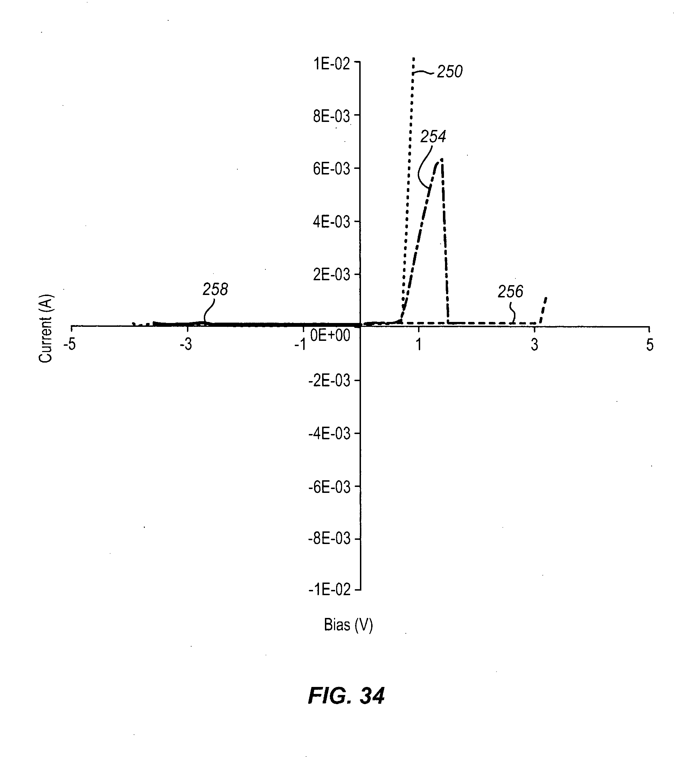

FIG. 34 is a graph comparing the voltage versus current curves for the JFET SET and RESET functions of the M/CEM/M-JFET switching cell 400 of FIG. 19 with nickel oxide as the CEM with nickel oxide as the CEM, and also comparing these curves for the voltage versus current curve of the JEFET. The well-known JFET curve is at 250, the ON curve leading to the RESET function is at 254, and the OFF curve leading to the SET function is at 256. As can be seen from the figure, no switching is possible when the JFET gate/drain junction is reverse biased. With forward bias, the device does not conduct until a threshold is reached and then the current rises exponentially. With the CEM device formed over the diode, the current is essentially zero up to the threshold voltage, due to the action of the diode, then rises, but not quite so quickly, due to the resistance of the CEM layer. The threshold voltage is about 0.8 volts for this diode. At about 1.4 volts, the current begins to drop and becomes essentially zero at about 1.6 volts, as the resistance has greatly increased. Then, at about 3.1 volts, the current again increases, indicating the CEM material has switched back to a low resistance state. If the voltage is lowered, the current will follow the ON curve. A feature of M/CEM/M-JFET device 400 is that resistive switching occurs only when the JFET is forward biased. Reverse bias prohibits switching. This is a significant improvement over prior art memories as this feature prevents disturb in a cross-tie memory.

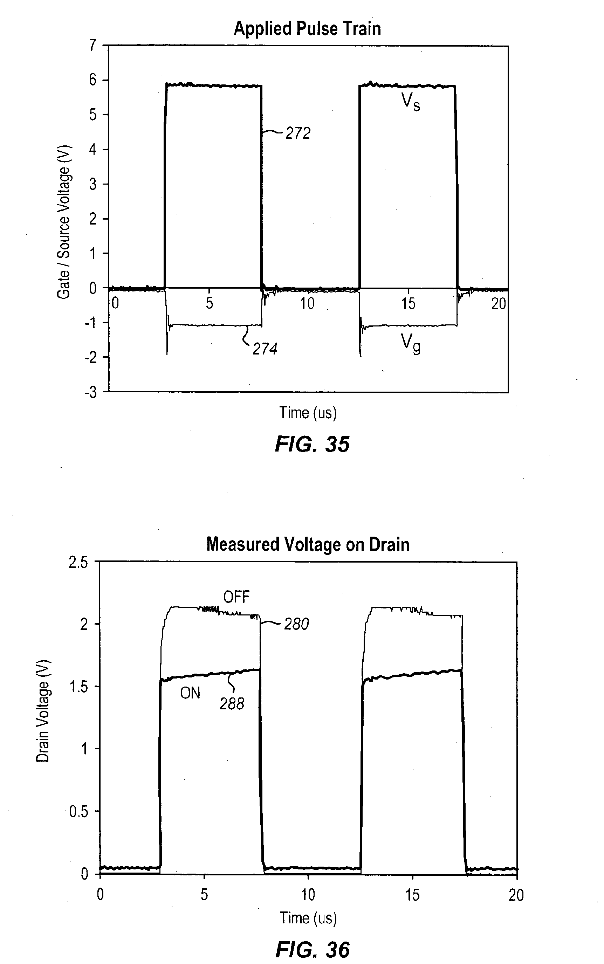

FIG. 35 is a graph showing time versus voltage for voltage pulses applied to the gate and source of the switching cell 400 of FIG. 19 with nickel oxide as the CEM, and FIG. 36 is a graph showing the measured voltage on the drain of the switching cell 400 of FIG. 19 in response to the voltage pulses applied as show in FIG. 34. In FIG. 34, the gate voltage is the approximately negative one volt curve 274 and the source voltage is the approximately six volt curve 272. Since the gate voltage puts a reverse bias on the M/CEM/M stack 404, no switching occurs. When the CEM layer is ON, essentially no gate voltage is dropped on the CEM resistor, thus the gate bias is the applied bias of about -1 volt. When the CEM resist is OFF, significant gate voltage drops across the CEM layer, thus the gate sees less bias voltage. Thus, the gate voltage when the CEM switch is ON is larger than the gate voltage when the CEM switch is OFF, and in the ON state the JFET channel will be small, i.e., closer to pinch-off, and thus the measured drain voltage is lower at 288 for the ON state than at 280 for the ON state. Thus, the state of the switching CEM element 404 effectively controls drain voltage by modulation the JFET transconductance. The difference between the drain voltage more than half a volt, and thus is easily measured. Thus, the M/CEM/M-JFET 19 provides added insurance that memory readout will be a no-disturb non-destructive memory readout when the source and gate of the device is pulsed.

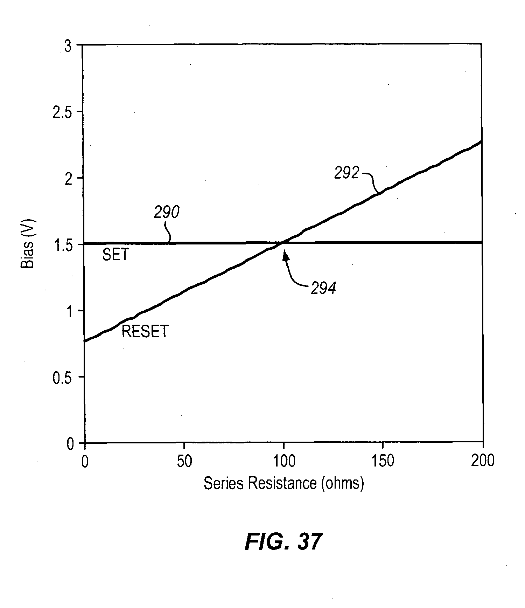

FIG. 37 is a graph of the resistance of the CEM and parasitic resistance of the interconnects in series versus the SET bias voltage and versus the RESET voltage, showing that high parasitic resistance will create an unstable condition. The parasitic resistance and the CEM resistance act as a voltage divider, with the voltage drop over each being roughly proportional to the resistance. The SET voltage curve 290 is flat, because the parasitic resistance is negligible as compared to the resistance of the OFF state. The voltage required to RESET the CEM rises as the series resistance rises. At the point 294, the RESET voltage becomes larger than the SET voltage. In this condition, when the RESET voltage is reached, the CEM will suddenly become insulative, and the system will fall down to the line 290, and the system will then want to SET, or change to the conductive state. Thus, the material will oscillate between the conductive and insulative states. To avoid this, the parasitic resistance should be kept below about 50 Ohms. For this reason, raw array type memories, as suggested by some prior art papers, will not work unless they are subdivided into smaller arrays.

According to one aspect of the invention, thin films of resistive correlated electron material, such as nickel oxide, are deposited via a liquid deposition process, preferably a process in which carbon is introduced into the material. These processes include MOCVD, spin on, dipping, liquid source misted deposition, atomic layer deposition (ALD), other CSD (chemical solution deposition) methods, or by depositing a metal and then oxidizing it with a carbon donor compound present in the atmosphere. In the preferred CSD methods, metallorganic precursors are deposited and reacted to form the desired material. Octane is the preferred solvent for the transition oxide precursors. Single layer films showed cracking, but multilayer films were of electronic device quality. These represent "first try" results, and the experience of the Applicants indicates that good extremely thin films are possible with any liquid source deposition process, including MOCVD and with the process of depositing a metal and then oxidizing it. Results with a furnace anneal of 450°C show that on Pt, the films are smooth and are fine-grained. We have shown that the results remain good with anneals in the range of 550°C to 650°C. Also, as discussed more fully elsewhere, it is found to be advantageous to include carbon ligand doping in the material. Further, it has been found that annealing in a gas containing the ligand materials is advantageous. Further, the gas preferably also includes the anion to which the ligand bonds the metal. For example, annealing of nickel oxide in carbon monoxide (CO) or carbon dioxide ($CO_2$ provides the carbon ligand and the oxygen anion in the metal-ligand-anion bonds that stabilize the nickel oxide. Alternatively, the CEM materials may be sputtered and then annealed in the ligand-containing gas, or may be reactive sputtered in the ligand-containing gas. For example, nickel may be reactive sputtered in CO or $CO_2$.

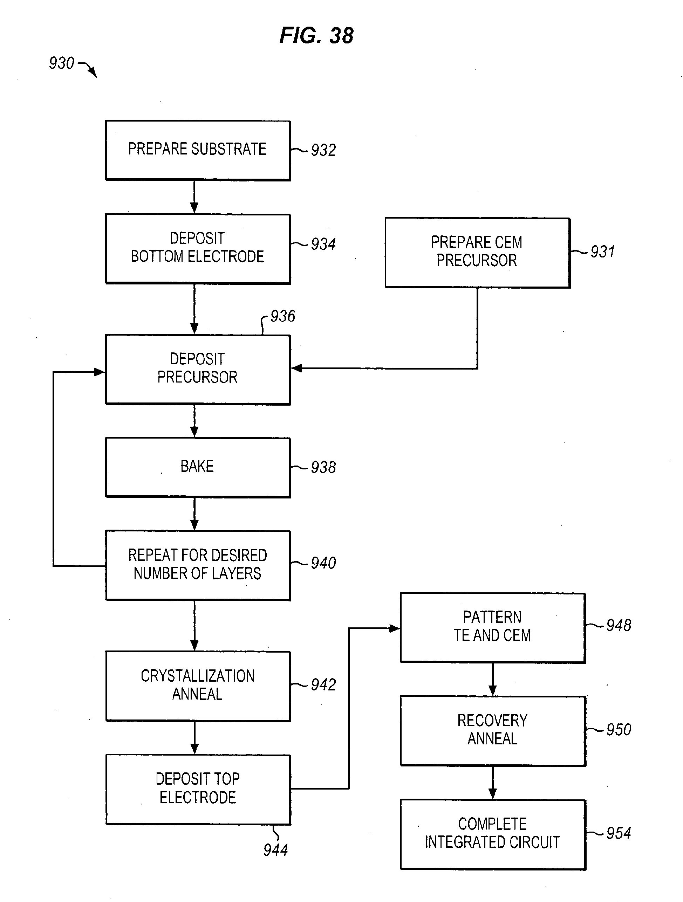

FIG. 38 is a flow chart showing the preferred process 930 of fabricating the CEM sandwich elements of FIGS. 3 and 4. In process 932 a substrate is prepared. The substrate is preferably a silicon wafer with a silicon oxide coating. The substrate may be baked to remove any contaminants. Simultaneously, at 931, a CEM precursor is prepared. The precursor contains metal moieties suitable for forming the desired CEM or other variable resistance material upon deposition and heating. For example, if nickel oxide is the desired variable resistance material, then the precursor will contain nickel. The precursor is preferably a liquid containing carbon, preferably a metallorganic precursor. This may be an off-the-shelf precursor purchased from a chemical company, such as Kojundo Chemical Co. of Tokyo Japan. Or the precursor may be prepared just prior to deposition.

At 934 a bottom electrode is deposited. This electrode may include an adhesion layer and/or a barrier layer as known in the art. Preferably, the electrode is platinum. Then, the precursor is deposited in process 936. The may be any of the processes mentioned above. After depositing the precursor is heated to form a crystallized CEM or other variable resistance material. In the preferred embodiment, the heating process comprises a bake process 938 and an anneal process 942. However, a wide variety of heating processes may be used, including baking on a hot plate, furnace anneal, rapid thermal processing (RTP), sometimes called rapid thermal annealing (RTA), or any other process that will crystallize the film. In process 938, the deposited precursor on the wafer is baked, such as on a hot plate, and preferably at a temperature between 100°C and 300 °C for a time of between 1 minute and ten minutes. Preferably, two bakes are used at different temperatures, more preferably with the second bake at the higher temperature. The deposition and bake steps are repeated at 940 for as many times as required to obtain the desired thickness of films. After the desired thickness is reached, the dried layers are annealed to form a crystallized film at 942. Preferably, the annealing is at a temperature offrom 450 °C to 650 °C, with the lower temperature most preferred, and is for a time from 20 minutes to 1 hour. The anneal may be performed in oxygen or in a gas containing a desired ligand. At 944 the top electrode is deposited. This is preferably platinum.

The top electrode and CEM material is then patterned, preferably by a dry etch, and most preferably by ion milling with argon. The etch has been found to be helpful in obtaining stable materials. Then follows a recovery anneal, preferably at a temperature of from 450 °C to 650 °C and preferably for from 30 minutes to 1.5 hours, and preferably, in oxygen. The integrated circuit is then completed at 954 to include the CEM material, or other variable resistance material, as an active element in an integrated circuit. Here, "active element" means an element that changes in response to the application of current or voltage, in contrast to, say, a passivation insulator.

Example I

A 2000 A (Angstrom) layer of platinum was deposited on a wafer with a silicon dioxide coating. Then a 0.2 molar nickel oxide precursor in an octane solution was deposited by spin coating the platinum layer at 3000 rpm (rounds per minute). The nickel oxide precursor is available from Kojundo Chemical Company, Tokyo, Japan. The precursor was baked at 150 °C for 1 minute, and then at 260 °C for four minutes to produce an approximately 100 A dry layer. The spin-on deposition and baking processes were repeated six times for a total thickness of 600 Å. Then, a crystallization anneal was performed in a furnace at 450 °C in an oxygen atmosphere for 40 minutes to produce a 600 A layer of the CEM nickel oxide according to the invention. Electron microscopy revealed that a significant amount of carbon was present in the material, with the carbon coming from the octane precursor. A top electrode of 2000 A of platinum was deposited. Then, the top electrode and CEM layer were patterned by dry etching, preferably ion milling, down to the bottom electrode platinum layer. Finally, a recovery anneal was performed in a furnace at 450 °C in an oxygen atmosphere for approximately one hour to produce the films discussed with respect to FIGS. 9-12 above.

Example II

This example was made in the same way as Example I above except that 5% ammonia was added to the precursor. The films produced yielded similar results.

The invention includes an annealing process for CEMs. The CEM may be annealed in a gas containing at least one chemical element for forming a ligand which stabilizes the electronic properties of the CEM. Preferably, the CEM is a transition metal and the chemical element comprises carbon. Preferably, the gas comprises a gas selected from CO and $CO_2$ Preferably, the CEM is nickel.

The invention also provides a sputtering method of making a CEM. The material may be sputtered, and then annealed as described above. Or reactive sputtering of the CEM in a gas containing at least one chemical element for forming a ligand which stabilizes the electronic properties of the CEM may be employed. Preferably, the CEM is a transition metal and the chemical element comprises carbon. Preferably, the gas comprises a gas selected from CO and $CO_2$. Preferably, the CEM is nickel oxide.

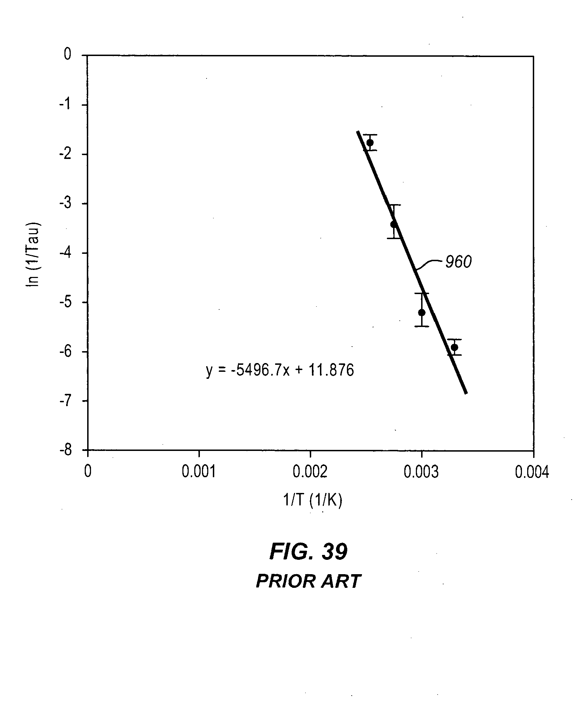

FIG. 39 is an Arrhenius curve of the log of 1/Tau versus 1/T(1/K) for prior art sputtered NiO (without carbon) illustrating that the transition from the high resistance state to the low resistance state is caused by detrapping of electrons from oxygen vacancies in the sputtered NiO. To generate this Arrhenius curve the relaxation time for the material to return to the insulative state after SET, Tau, was measured for a number of temperatures in the working range of a proposed variable resistance memory (below 70 °C) for NiO films made by sputtering and without including any carbon ligand. As known in the art, the slope of the Arrhenius curve 960 is proportional to the activation energy for the mechanism that is causing the relaxation. The slope found from curve 960 yields an activation energy of approximately 0.47 eV. This is essentially the activation energy for detrapping of electrons from oxygen vacancies in NiO. See, "Surface Metallic Nature Caused By An In-Gap State Of Reduced NiO: A Photoemission Study", N. Nakajima et al., Journal of Electron Spectroscopy and Related Phenomena, 144 147 (2005) pp. 873-875. Thus, the variable resistance phenomenon of the prior art NiO devices is dominated by the trapping and detrapping of electrons in oxygen vacancies.

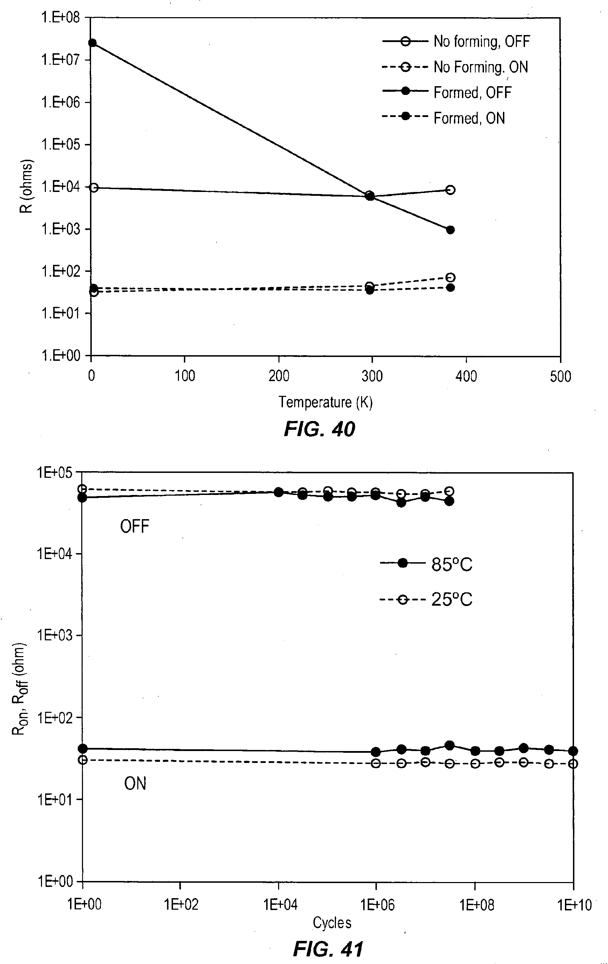

FIG. 40 shows a graph of Kelvin temperature versus resistance in Ohms for the ON and OFF states for a CEM thin film according to the invention and for a prior art thin film that crystallizes in the OFF state and requires forming before exhibiting variable resistance. As shown in the graph, for the CEM material, $NiO(C_x)$ in this case, the ON and OFF states vary only a little with temperature over the entire 400 °K temperature range. Both curves rise a little at the higher temperatures. The rise is essentially uniform for both the ON and OFF state, so the resistance window remains essentially the same. Clearly, a memory made with the CEM material will be stable over any temperature range that memories should be stable over. However, for the prior art NiO film, without carbon, the OFF state changes linearly with temperature, while the conducting state is essentially flat. The resistance window changes by more than 500%. Just over the reasonable range that a memory must work, from about 250 °K to about 350 °K, the memory window changes by about over 100%. This prior art material clearly could not be used in a memory.

FIG. 41 is a graph of number of reading cycles versus resistance in Ohms for the ON and OFF states for a CEM thin film according to the invention. Measurements were made at both 25 °C and 85 °C. Reading fatigue measures the resistance in Ohms versus number of read cycles, where a read cycle comprises the application of a read voltage of one volt across the resistance element for a sufficient time to come to equilibrium with a reference voltage, followed by the removal of the voltage for a sufficient time to come to equilibrium at zero voltage. The measurements of reading fatigue were made for both the ON state and the OFF state at 85 °C and 25°C. The ON state was measured out to $10^{10}$ cycles and the OFF state was measured only to $10^8$ cycles because of time constraints. Both curves were flat, i.e., showing essentially no change in the measured resistance values, for the 25°C measurement, and showing a minor variation of about two percent for the 85°C measurement. This graph demonstrates there is little or no fatigue for the CEM material. Thus, a memory made of CEM material will be stable over any conceivable number of read cycles. Write fatigue has not yet been measured due to time constraints, though every indication is that it also will be essentially nil.

It is a feature of the invention that the effect of oxygen vacancies is canceled in the CEMs according to the invention. The fact that the CEM materials are in the low resistance state, or ON state, as-deposited demonstrates this vacancy coordination passivation effect. The vacancy coordination sphere is the region about an ion or electron in which vacancies can effect the ion or electron. As shown by FIG, 39, vacancies within this vacancy coordination sphere trap electrons which are subsequently thermally detrapped. This destabilizes the high resistance state. This is the principle reason for the instability of prior art variable resistance materials. In the materials according to the invention, the effect of the oxygen vacancies is cancelled, by the ligand structure of the CeRAM materials according to the invention. As shown by FIGS. 10, 11 and 40, the resistance states of the CEMs according to the invention are thermally stable. This further demonstrates vacancy coordination passivation.

The particular systems, memory designs, and methods described herein are intended to illustrate the functionality and versatility of the invention, but the invention should not be construed to be limited to those particular embodiments. It is evident that those skilled in the art may make numerous uses and modifications of the specific embodiments described, or equivalent structures and processes may be substituted for the structures and processed described. For example, the memory is shown with the electronic phase change elements and their associated transistors arranged in columns. The phase change elements may just as well have been arranged in rows. Thus, herein, the arrangement is referred to as a row/column arrangement. Further, while in some instances the preferred type of semiconductor wafer has been specified, it should be understood that in any of the devices described, any semiconductor can be used. Further, in many instances the specific type of semiconductor has been specified, e.g., n-type, p-type, n+, p+, etc., those skilled in the art will recognize that other types may be used. For example, most devices work essentially the same if n-type is replaced with p-type and p-type replaced with n-type. As another example, though platinum electrodes have been given as examples, those skilled in the art will recognize that such electrodes are preferably formed with a thin adhesive layer of titanium, and that the entire literature of oxide structures on platinum/titanium electrodes and the top electrode literature involving platinum, titanium, tungsten, and other materials can be applied. Any place a semiconductor is mentioned, those skilled in the art will recognize that gallium arsenide, germanium, germanium/silicon and other semiconductor technologies can be substituted. As mentioned above, the term "metal" or "M" is used herein to indicate any suitable conductor, including metals such as platinum and tungsten, or polysilicon or other conventional conductors known in the art. Since certain changes may be made in the above systems and methods without departing from the scope of the invention, it is intended that all subject matter contained in the above description or shown in the accompanying drawings may be interpreted as illustrative and not in a limiting sense.

## Claims

1. A resistive switching integrated circuit memory comprising; a resistive switching memory cell; a write circuit for placing said resistive switching memory cell in a first resistive state or a second resistive state depending on information input into said memory, wherein the resistance of said resistive switching memory cell is higher in said second resistance state than in said first resistance state; and a read circuit for sensing the state of said memory cell and providing and electrical signal corresponding to the sensed state of said memory cell; said resistive switching memory **characterized in that** said resistive switching memory cell includes a correlated electron material (CEM) comprising a transition metal oxide and an extrinsic ligand.

2. A resistive switching memory as in claim 1 wherein said memory is capable of being read $10^8$ times with less than 50% fatigue.

3. A resistive switching memory as in claim 1 wherein said memory has a memory window that changes less than 50% over a temperature range of from minus 50°C to 75°C.

4. A resistive switching memory as in claim 1 wherein said CEM comprises a transition metal oxide selected from the group consisting of aluminum, cadmium, chromium, cobalt, copper, gold, iron, manganese, mercury, molybdenum, nickel, palladium, rhenium, ruthenium, silver, thin, titanium, vanadium, zinc and combinations thereof.

5. A resistive switching memory as in claim I wherein said CEM is essentially homogeneous.

6. A resistive switching memory as in claim 1 wherein said extrinsic ligand comprises carbon or ammonia.

7. A method of forming a resistive switching memory, said method comprising:

   providing a substrate;
   forming a transition metal oxide on said substrate; and
   completing said memory to include said transition metal oxide in an active element in said memory; wherein said method is **characterized by** said forming a transition metal oxide comprising crystallizing said transition metal oxide directly into a conducting state without an electroforming process.

8. A method as in claim 7 and further comprising writing to said resistive switching memory element by applying ain electric field or voltage to said memory element to cause the concentration of electrons, $n_c$, in an energy band in the majority of the volume of said memory element to increase to or greater than a value given by $(n_c)^{1/3}a = 0.26$ where "a" is the Bohr radius.

9. A resistive switching memory as in claim 6 wherein said extrinsic ligand comprises a form of CO.

**Patentansprüche**

1. Widerstandsgeschalteter Speicher in einer integrierten Schaltung, der aufweist: eine widerstandsgeschaltete Speicherzelle; eine Schreib-Schaltung, um die widerstandsgeschaltete Speicherzelle in einen ersten Widerstandszustand oder einen zweiten Widerstandszustand zu bringen, abhängig von Informationseingabe in den Speicher, wobei der Widerstand der widerstandsgeschalteten Speicherzelle in dem zweiten Widerstandszustand höher ist als in dem ersten Widerstandszustand; und eine Lese-Schaltung zum Erfassen des Zustandes der Speicherzelle und zum Bereitstellen eines elektrischen Signals, das dem erfassten Zustand der Speicherzelle entspricht; wobei der widerstandsgeschaltete Speicher **dadurch gekennzeichnet ist, dass** die widerstandsgeschaltete Speicherzelle ein Material mit korrelierten Elektronen (CEM *Correlated Electron Material*) umfasst, das ein Übergangsmetalloxid und einen extrinsischen Liganden aufweist.

2. Widerstandsgeschalteter Speicher nach Anspruch 1, wobei der Speicher $10^8$ mal gelesen werden kann, mit einem Ermüdungsgrad von weniger als 50 %.

3. Widerstandsgeschalteter Speicher nach Anspruch 1, wobei der Speicher ein Speicherfenster hat, das sich um weniger als 50 % über einen Temperaturbereich von minus 50°C bis 75°C ändert.

4. Widerstandsgeschalteter Speicher nach Anspruch 1, bei dem das CEM ein Übergangsmetalloxid aufweist, das aus der Gruppe bestehend aus Aluminium, Cadmium, Chrom, Kobalt, Kupfer, Gold, Eisen, Mangan, Quecksilber, Molybdän, Nickel, Palladium, Rhenium, Ruthenium, Silber, Zinn, Titan, Vanadium, Zink und Kombinationen aus diesen ausgewählt ist.

5. Widerstandsgeschalteter Speicher nach Anspruch 1, bei dem das CEM im Wesentlichen homogen ist.

6. Widerstandsgeschalteter Speicher nach Anspruch 1, bei dem der extrinsische Ligand Kohlenstoff oder Ammoniak aufweist.

7. Verfahren zum Bilden eines widerstandsgeschalteten Speichers, wobei das Verfahren aufweist:

   Bereitstellen eines Substrats;
   Bilden eines Übergangsmetalloxids auf dem Substrat; und
   Vervollständigen des Speichers, um das Übergangsmetalloxid in ein aktives Element in dem Speicher einzuschließen; wobei das Verfahren **gekennzeichnet ist durch** das Bilden eines Übergangsmetalloxids, welches das Kristallisieren des Übergangsmetalloxids direkt in einen leitenden Zustand ohne einen Galvanisierprozess aufweist.

8. Verfahren nach Anspruch 7 und weiter das Schreiben in das widerstandsgeschaltete Speicherelement aufweisend, indem ein elektrisches Feld oder eine Spannung an das Speicherelement angelegt wird, um zu bewirken, dass die Konzentration an Elektronen, $n_c$, in einem Energieband in dem Hauptanteil des Volumens des Speicherelements anwächst auf oder größer ist als ein Wert, der durch $(n_c)^{1/3}a = 0.26$ gegeben ist, wobei "a" der Bohrsche Radius ist.

**9.** Widerstandsgeschalteter Speicher nach Anspruch 6, bei dem der extrinsische Ligand eine Form des CO aufweist.

## Revendications

**1.** Mémoire de commutation résistive à circuit intégré, comprenant : une cellule de mémoire de commutation résistive ; un circuit d'écriture pour placer ladite cellule de mémoire de commutation résistive dans un premier état résistif ou un second état résistif, en fonction d'informations introduites dans ladite mémoire, dans laquelle la résistance de ladite cellule de mémoire de commutation résistive est supérieure dans ledit second état résistif à celle dudit premier état résistif ; et un circuit de lecture pour détecter l'état de ladite cellule de mémoire et fournir un signal électrique correspondant à l'état détecté de ladite cellule de mémoire ; ladite mémoire de commutation résistive étant **caractérisée en ce que** ladite cellule de mémoire de commutation résistive comprend une substance à électrons corrélés (CEM) comprenant un oxyde métallique de transition et un ligand extrinsèque.

**2.** Mémoire de commutation résistive selon la revendication 1, dans laquelle ladite mémoire est apte à être lue $10^8$ fois avec moins de 50 % de fatigue.

**3.** Mémoire de commutation résistive selon la revendication 1, dans laquelle ladite mémoire présente une fenêtre de mémoire qui évolue de moins de 50 % sur une plage de températures allant de - 50 °C à + 75 ° C.

**4.** Mémoire de commutation résistive selon la revendication 1, dans laquelle ladite substance CEM comprend un oxyde métallique de transition choisi dans le groupe comportant les éléments ci-après : l'aluminium, le cadmium, le chrome, le cobalt, le cuivre, l'or, le fer, le manganèse, le mercure, le molybdène, le nickel, le palladium, le rhénium, le ruthénium, l'argent, l'étain, le titane, le vanadium, le zinc et des combinaisons de ces éléments.

**5.** Mémoire de commutation résistive selon la revendication 1, dans laquelle ladite substance CEM est essentiellement homogène.

**6.** Mémoire de commutation résistive selon la revendication 1, dans lequel ledit ligand extrinsèque comprend du carbone ou de l'ammoniac.

**7.** Procédé de formation d'une mémoire de commutation résistive, ledit procédé comprenant :

la fourniture d'un substrat ;

la formation d'un oxyde métallique de transition sur ledit substrat ; et

l'achèvement de ladite mémoire en vue d'inclure ledit oxyde métallique de transition dans un élément actif au sein de ladite mémoire ; dans lequel ledit procédé est **caractérisé en ce que** ladite formation d'un oxyde métallique de transition comporte la cristallisation dudit oxyde métallique de transition directement dans un état conducteur sans processus d'électroformage.

**8.** Procédé selon la revendication 7, comprenant en outre l'écriture sur ledit élément de mémoire de commutation résistive par l'application d'un champ électrique ou d'une tension audit élément de mémoire, en vue d'amener la concentration d'électrons, $n_c$, dans une bande d'énergie de la majorité du volume dudit élément de mémoire, à augmenter vers, ou à être supérieure à une valeur donnée par $(n_c)^{1/3}a = 0,26$ où « a » est le rayon de Bohr.

**9.** Mémoire de commutation résistive selon la revendication 6, dans laquelle ledit ligand extrinsèque comprend une forme de cobalt, CO.

**FIG. 1**

**FIG. 2**

**FIG. 3**

**FIG. 4**

NiO (C$_x$)

FIG. 5

NiO (C$_x$) w/ Co 5%

FIG. 6

FIG. 7

FIG. 8

*FIG. 9*

*FIG. 10*

**FIG. 11**

**FIG. 12**

(a) $\Delta_t$ is large

Increasing $U$

*metal*      *Mott-Hubbard insulator*

184   d band    190

$W$

$E_F$

183

182

W

189

p band   188

$U$

$\Delta_t$

$(N+1)$ electrons

$N$ electrons

$(N-1)$ electrons

A hole is created in
the lower Hubbard band
when $N$ is reduced to $(N-1)$

**FIG. 13**

(b) $\Delta_t$ is small

Increasing $U$

*metal*      *charge transfer-type insulator*

193   d band    196

$W$

$E_F$

192

195

W

p band

191    194

$\Delta_t$

$U$

$(N+1)$ electrons

$N$ electrons

$(N-1)$ electrons

A hole is created in
the p band when $N$
is reduced to $(N-1)$

**FIG. 14**

**FIG. 15**

**FIG. 16**

**FIG. 17**

**FIG. 18**

**FIG. 19**

FIG. 20

FIG. 21

FIG. 22

FIG. 23

FIG. 24

FIG. 25

Cross Section

FIG. 26

FIG. 27

**FIG. 28**

**FIG. 29**

**FIG. 30**

**FIG. 31**

**FIG. 32**

**FIG. 33**

**FIG. 34**

## Applied Pulse Train

**FIG. 35**

## Measured Voltage on Drain

**FIG. 36**

*FIG. 37*

## FIG. 38

930

```
PREPARE SUBSTRATE    ~932
        |
        v
DEPOSIT
BOTTOM ELECTRODE     ~934          PREPARE CEM
                                   PRECURSOR        ~931
        |
        v  ~936
DEPOSIT
PRECURSOR
        |
        v
BAKE                 ~938
        |
        v
REPEAT FOR DESIRED
NUMBER OF LAYERS     ~940
        |
        v
CRYSTALLIZATION                    PATTERN
ANNEAL               ~942          TE AND CEM       ~948
        |                              |
        v                              v
DEPOSIT TOP                        RECOVERY
ELECTRODE                          ANNEAL           ~950
                                       |
       944                             v
                                   COMPLETE
                                   INTEGRATED CIRCUIT  ~954
```

**FIG. 39**
**PRIOR ART**

**FIG. 40**

**FIG. 41**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7038935 B, Darrell Rinerson
- US 6903361 B, Terry L. Gilton
- US 6841833 B, Sheng Teng Hsu
- US 6624463 B, Hyun-Tak Kim

- US 20070114509 A1
- EP 1489068 A
- EP 1484799 A

### Non-patent literature cited in the description

- **STEPHAN LAI.** Current Status of the Phase Change Memory and Its Future. Intel Corporation, 2005
- **B. J. CHOI et al.** Resistive Switching Mechanisms of TiO2 Thin Films Grown By Atomic-Layer Deposition. *Journal of Applied Physics,* 2005, vol. 98, 033715
- **JAE-WAN PARK et al.** Reproducible Resistive Switching In Nonstoichiometric Nickel Oxide Films Grown By RF Reactive Sputtering For Resistive Random Access Memory Applications. *J. Vac. Sci. Technol.,* September 2005, vol. A 23 (5
- **JAE-WAN PARK et al.** Influence Of Oxygen Content On Electrical Properties Of NiO films grown By RF Reactive Sputtering. *J. Vac. Sci. Technol.,* September 2006, vol. B 24 (5

- **I.H. INONE et al.** Nonpolar Resistance Switching Of Metal/Binary-Transition-Metal Oxides/Metal Sandwiches: Homogeneous/inhomogeneous Transition of Current Distribution. *arXiv:Cond-mat/0702564,* 26 February 2007, vol. 1
- Ligand Field Theory. Wikepedia
- **UICHIRO MIZUTANI.** Introduction to the Electron Theory of Metals. Cambridge University Press, 2001, 444-447
- **LESLIE E. ORGAL.** An Introduction to Transition-Metal Chemistry: Ligand-Field Theory. Methuen & Co. Ltd, 1960
- **NEVILL MOTT.** Metal-Insulator Transitions. Taylor & Francis, 1990
- The Hubbard Model. World Scientific, 1992
- **N. NAKAJIMA et al.** Surface Metallic Nature Caused By An In-Gap State Of Reduced NiO: A Photoemission Study. *Journal of Electron Spectroscopy and Related Phenomena,* 2005, vol. 144 (147), 873-875